(19)

Europäisches
Patentamt
European
Patent Office
Office européen
des brevets

(11) **EP 4 294 049 A1**

(12) **EUROPEAN PATENT APPLICATION**
published in accordance with Art. 153(4) EPC

(43) Date of publication:
**20.12.2023 Bulletin 2023/51**

(21) Application number: **22893946.8**

(22) Date of filing: **27.04.2022**

(51) International Patent Classification (IPC):
**H04R 17/00** (2006.01)    **H04R 1/00** (2006.01)

(86) International application number:
**PCT/CN2022/089572**

(87) International publication number:
**WO 2023/206143 (02.11.2023 Gazette 2023/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Shenzhen Shokz Co., Ltd.**
**Shenzhen, Guangdong (CN)**

(72) Inventors:
• **ZHU, Guangyuan**
  **Shenzhen, Guangdong 518108 (CN)**
• **ZHANG, Lei**
  **Shenzhen, Guangdong 518108 (CN)**
• **QI, Xin**
  **Shenzhen, Guangdong 518108 (CN)**
• **WANG, Qingyi**
  **Beijing 100015 (CN)**

(74) Representative: **Wang, Bo**
**Panovision IP**
**Ebersberger Straße 3**
**85570 Markt Schwaben (DE)**

(54) **ACOUSTIC OUTPUT DEVICE**

(57)     Embodiments of the present disclosure provide an acoustic output device comprising: a vibration element having a beam structure extending along a length direction of the vibration element; a piezoelectric element configured to deform in response to an electrical signal, the deformation of the piezoelectric element driving the vibration element to vibrate, wherein the piezoelectric element is attached to a first position of the beam structure, and a size of an attachment area along the length direction does not exceed 80% of a size of the beam structure along the length direction; and a mass element connected to a second position of the beam structure, wherein the first position and the second position are spaced apart along the length direction, and the vibration of the vibration element drives the mass element to vibrate in a direction perpendicular to the length direction.

FIG. 1

**Description**

**TECHNICAL FIELD**

The present disclosure relates to the acoustic technology field, and in particular to an acoustic output device.

**BACKGROUND**

A piezoelectric acoustic output device utilizes an inverse piezoelectric effect of a piezoelectric material to produce a vibration and radiate a sound wave outward. Compared to a traditional electrodynamic speaker, the piezoelectric acoustic output device has the advantages of high electromechanical conversion efficiency, low energy consumption, small size, and high integration, etc. Under the current trend of miniaturization and integration of devices, the piezoelectric acoustic output device has an extremely broad prospect and future. However, the piezoelectric acoustic output device has problems such as poor low-frequency response, etc., which leads to low sensitivity of the piezoelectric acoustic output device within a low frequency range (e.g., 50 Hz to 2000 Hz).

Therefore, it is desirable to provide an acoustic output device to improve a low frequency response of the piezoelectric acoustic output device, thereby improving a sensitivity of the acoustic output device in the low frequency range.

**SUMMARY**

According to embodiments of the present disclosure, an acoustic output device is provided. The acoustic output device includes a vibration element having a beam structure extending along a length direction of the vibration element, a piezoelectric element configured to deform in response to an electrical signal. The deformation of the piezoelectric element drives the vibration element to vibrate, wherein the piezoelectric element is attached to a first position of the beam structure, and a size of an attachment area along the length direction does not exceed 80% of a size of the beam structure along the length direction. The acoustic output device includes a mass element connected to a second position of the beam structure, wherein the first position and the second position are spaced apart along the length direction, and the vibration of the vibration element drives the mass element to vibrate in a direction perpendicular to the length direction.

In some embodiments, the vibration element resonates with the mass element to produce a first resonance peak, and a frequency of the first resonance peak is within a range of 50 Hz to 2000 Hz.

In some embodiments, the vibration of the vibration element and the mass element has a second resonance peak, and a ratio of a frequency of the second resonance peak to a frequency of the first resonance peak is greater than 5.

In some embodiments, between the first resonance peak and the second resonance peak, the vibration of the vibration element and the mass element produces at least one resonance valley, and an amplitude difference between the first resonance peak or the second resonance peak and the at least one resonance valley is less than 80 dB.

In some embodiments, a length of the beam structure is less than 50 mm.

In some embodiments, a mass of the mass element is less than 10 g.

In some embodiments, a deformation direction of the piezoelectric element is perpendicular to a vibration direction of the vibration element.

In some embodiments, a length of the piezoelectric element is within a range of 3 mm to 30 mm.

In some embodiments, the acoustic output device further includes a second piezoelectric element attached to a third position of the beam structure, wherein the piezoelectric element and the second piezoelectric element are spaced apart in the length direction of the vibration element.

In some embodiments, a distance between the piezoelectric element and the second piezoelectric element is less than 25 mm.

In some embodiments, the beam structure includes a fixing end, and a distance between the piezoelectric element or the second piezoelectric element and the fixing end is greater than 3 mm.

In some embodiments, the piezoelectric element and the second piezoelectric element are located on a same side of the beam structure in a vibration direction of the beam structure.

In some embodiments, the piezoelectric element and the second piezoelectric element are respectively located at both sides of the beam structure in a vibration direction of the beam structure.

In some embodiments, the acoustic output device further includes a second mass element, wherein the mass element and the second mass element are respectively located at both sides of the piezoelectric element in the length direction of the vibration element.

In some embodiments, a mass of the second mass element is greater than a mass of the mass element.

In some embodiments, a ratio of the mass of the second mass element to the mass of the mass element is within a range of 0 to 10.

In some embodiments, a deformation direction of the piezoelectric element is parallel to a vibration direction of the vibration element.

In some embodiments, the piezoelectric element is fixed at one end along the vibration direction of the piezoelectric element, and another end of the piezoelectric element is connected to the beam structure at the first position.

In some embodiments, the beam structure includes a fixing end, and a ratio of a distance between the first position and the fixing end to a length of the beam structure is less than 0.6.

In some embodiments, the acoustic output device further includes a second vibration element, wherein the vibration element and the second vibration element are arranged symmetrically at both sides of the mass element.

In some embodiments, the acoustic output device further includes a third piezoelectric element connected to the second vibration element, wherein the third piezoelectric element and the piezoelectric element are arranged symmetrically at the both sides of the mass element.

In some embodiments, one end of the vibration element away from the mass element and one end of the second vibration element away from the mass element are fixedly arranged.

In some embodiments, the acoustic output device further includes a third vibration element connected to the mass element.

In some embodiments, in a frequency range greater than 100 Hz, the third vibration element increases a vibration amplitude of the mass element.

In some embodiments, a ratio of a length of the third vibration element to a length of the vibration element is greater than 0.7.

In some embodiments, a vibration direction of the third vibration element is parallel to a vibration direction of the vibration element.

In some embodiments, the acoustic output device further includes a fourth piezoelectric element connected to the third vibration element.

In some embodiments, a deformation direction of the fourth piezoelectric element is perpendicular to the vibration direction of the third vibration element.

In some embodiments, electrical signals received by the piezoelectric element and the fourth piezoelectric element have a phase difference, the phase difference being less than 135°.

## BRIEF DESCRIPTION OF THE DRAWINGS

FIG. 1 is a block diagram illustrating a structure of an acoustic output device according to some embodiments of the present disclosure;

FIG. 2A is a schematic diagram illustrating a structure of an acoustic output device according to some embodiments of the present disclosure;

FIG. 2B is a schematic diagram illustrating a cross-section view of the acoustic output device shown in FIG. 2A perpendicular to a length direction of a vibration element;

FIG. 3A is a schematic diagram illustrating a structure of an acoustic output device according to some embodiments of the present disclosure;

FIG. 3B is a schematic diagram illustrating frequency response curves of acoustic output devices according to some embodiments of the present disclosure;

FIG. 4 is a schematic diagram illustrating a structure of an acoustic output device according to some embodiments of the present disclosure;

FIG. 5 is a schematic diagram illustrating frequency response curves of acoustic output devices according to some embodiments of the present disclosure;

FIG. 6 is a schematic diagram illustrating frequency response curves of acoustic output devices according to some embodiments of the present disclosure;

FIG. 7 is a schematic diagram illustrating a structure of an acoustic output device according to some embodiments of the present disclosure;

FIG. 8 is a schematic diagram illustrating frequency response curves of acoustic output devices according to some embodiments of the present disclosure;

FIG. 9 is a schematic diagram illustrating a structure of an acoustic output device according to some embodiments of the present disclosure;

FIG. 10 is a schematic diagram illustrating frequency response curves of acoustic output devices according to some embodiments of the present disclosure;

FIG. 11 is a schematic diagram illustrating frequency response curves of acoustic output devices according to some embodiments of the present disclosure;

FIG. 12 is a schematic diagram illustrating frequency response curves of acoustic output devices according to some embodiments of the present disclosure;

FIG. 13 is a schematic diagram illustrating frequency response curves of acoustic output devices according to some embodiments of the present disclosure;

FIG. 14 is a schematic diagram illustrating frequency response curves of acoustic output devices according to some embodiments of the present disclosure;

FIG. 15 is a schematic diagram illustrating frequency response curves of acoustic output devices according to some embodiments of the present disclosure;

FIG. 16 is a schematic diagram illustrating frequency response curves of acoustic output devices according to some embodiments of the present disclosure;

FIG. 17 is a schematic diagram illustrating a structure of an acoustic output device according to some embodiments of the present disclosure;

FIG. 18 is a schematic diagram illustrating frequency response curves of acoustic output devices according to some embodiments of the present disclosure;

FIG. 19 is a schematic diagram illustrating a structure of an acoustic output device according to some embodiments of the present disclosure;

FIG. 20 is a schematic diagram illustrating frequency response curves of acoustic output devices according to some embodiments of the present disclosure;

FIG. 21 is a schematic diagram illustrating frequency response curves of acoustic output devices according to some embodiments of the present disclosure; and

FIG. 22 is a schematic diagram illustrating frequency response curves of acoustic output devices according to some embodiments of the present disclosure.

## DETAILED DESCRIPTION

In order to illustrate the technical solutions related to the embodiments of the present disclosure, a brief introduction of the drawings referred to the description of the embodiments is provided below. Obviously, the drawings described below are only some examples or embodiments of the present disclosure. Those skilled in the art, without further creative efforts, may apply the present disclosure to other similar scenarios according to these drawings. Unless obviously obtained from the context or the context illustrates otherwise, the same numeral in the drawings refers to the same structure or operation.

The acoustic output device provided in the embodiments of the present disclosure may output a sound by generating a vibration through a piezoelectric element using an inverse piezoelectric effect. Generally, the piezoelectric element may adopt two working modes, namely d33 and d31. In the d33 working mode, a deformation direction (also called a displacement output direction) of the piezoelectric element is the same as an electrical direction (also called a polarization direction) of the piezoelectric element. The resonance frequency of the piezoelectric element is relatively high, an output amplitude is relatively small, and a low-frequency response is poor. In the d31 working mode, the deformation direction of the piezoelectric element is perpendicular to the electrical direction of the piezoelectric element. In the d31 working mode, although a sufficiently low-frequency peak may be provided by increasing a length of the piezoelectric element to increase the output amplitude, but in this case, the piezoelectric element may have many vibration modes in the audible range (for example, 20 Hz-20 kHz), which results from many peaks and valleys in the frequency response curve, so the sound quality of the acoustic output device (or a piezoelectric speaker) is still poor.

To solve the problems of poor low-frequency response and many modes in the audible range of the piezoelectric speaker, the acoustic output device provided in the embodiments of the present disclosure may include a vibration element, a piezoelectric element, and a mass element. The vibration element has a beam structure extending along a length direction of the vibration element. The piezoelectric element may deform in response to an electrical signal, and the deformation may drive the vibration element to vibrate. The piezoelectric element is attached to a first position of the beam structure, and a size of the attachment area along the length direction of the beam structure does not exceed 80% of the size of the beam structure along the length direction. The mass element may be attached to a second position of the beam structure. The first position and the second position are spaced apart along the length direction of the beam structure, and a vibration of the piezoelectric element may drive the mass element to vibrate in a direction perpendicular to the length direction. Resonances of the piezoelectric element and the mass element may make a frequency response curve of the acoustic output device have a first resonance peak in a low frequency band (e.g., 50 Hz to 2000 Hz), thereby improving a sensitivity of the acoustic output device in the low frequency band. In addition, vibrations of the piezoelectric element and the mass element have a second resonance peak in a high frequency band (e.g., 2000 Hz to 20,000 Hz). There is at least one resonance valley between the first resonance peak and the second resonance peak, and an amplitude difference between the first resonance peak or the second resonance peak and the at least one resonance valley is less than 80 dB, thereby obtaining a flatter vibration response curve in a range from low to high frequencies, and improving the sound quality of the acoustic output device.

The acoustic output device provided by embodiments of the present disclosure effectively improves the sensitivity of the acoustic output device in the low frequency band by attaching a piezoelectric element to a vibration element having a beam structure and using an elastic mass system, which has elasticity provided by the beam structure with specific length and mass provided by the mass element, to output a vibration such that the frequency response curve of the acoustic output device has resonance peaks in the low frequency band. In some embodiments, the acoustic output device provided by the embodiments of the present disclosure further reduces vibration modes in the audible range of the human ear, for example, the frequency response curve has no or fewer resonance valleys or the amplitude difference between the resonance peak and the resonance valley is reduced, so that the frequency response curve of the acoustic output device in the audible range is relatively flatter, ensuring that the acoustic output device has a relatively better sound quality.

The acoustic output device provided by the exemplary embodiments of the present disclosure is further illustrated in detail with reference to the drawings.

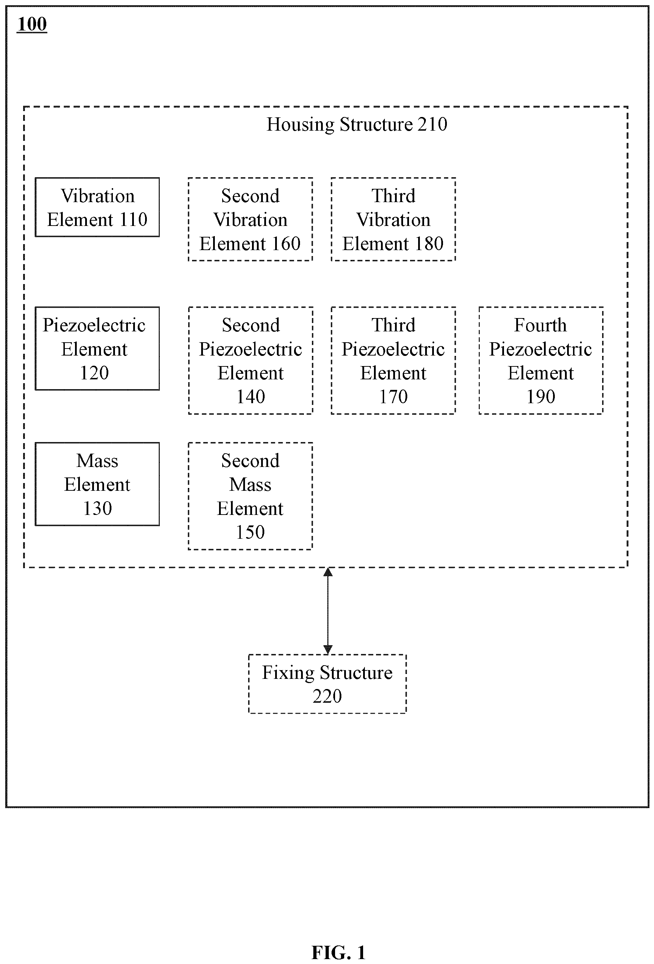

FIG. 1 is a block diagram illustrating a structure of an acoustic output device according to some embodiments of the present disclosure. In some embodiments, an acoustic output device 100 may be a bone conduction acoustic output device, an air conduction acoustic output device, or a combined bone-air conduction acoustic output device. In some embodiments, the acoustic output device 100 may include a stereo, a headphone, glasses, a hearing aid, an augmented reality (AR) device, a virtual reality (VR) device, etc., or other devices (e.g., cell phones, computers, etc.) with a capability of audio playback. In some embodiments, the acoustic output device 100 may include a vibration element 110, a piezoelectric element 120, and a mass element 130.

The vibration element 110 may produce a vibration based on a deformation of the piezoelectric element 120, such that the acoustic output device 100 may output the vibration through the mass element 130. For example, the piezoelectric element 120 may deform in response to an electrical signal, and the deformation of the piezoelectric element 120 may drive the vibration element 110 to vibrate in a polarization direction of the piezoelectric element 120, which in turn drives the mass element 130 to vibrate in the polarization direction of the piezoelectric element 120. In some embodiments, the vibration direction of the mass element 130 is perpendicular to a length direction of the vibration element 110. In some embodiments, the vibration element 110 may be a beam structure along the length direction of the vibration element, the piezoelectric element 120 may be attached to a first position of the beam structure, and the mass element 130 may be attached to a second position of the beam structure. The first position and the second position are spaced apart along the length direction of the vibration element 110 (also referred to as the beam structure). For example, the first position and the second position may be respectively located on both ends of the length direction of the beam structure. As another example, the first position and the second position may be located at any two positions along the length direction of the beam structure, and there is a preset distance between the first position and the second position.

In some embodiments, the piezoelectric element 120 may be attached directly to the first position of the vibration element 110 through an adhesive connection. In some embodiments, the piezoelectric element 120 may be attached to the first position of the vibration element 110 through a clamping connection, a fastening connection, etc. In some embodiments, the piezoelectric element 120 may be attached to the first position of the vibration element 110 through physical deposition or chemical deposition. In some embodiments, the mass element 130 may be attached to the second position of the vibration element 110 through the adhesive connection, clamping connection, welding connection, threaded connection, etc.

In some embodiments, adjusting a size of an attachment area (i.e., an actual contact surface between the piezoelectric element 120 and the vibration element 110) between the piezoelectric element 120 and the first position of the beam structure along the length direction of the beam structure, a range of a frequency response curve of the acoustic output device 100 in the audible range of the human ear may be increased so that the sound quality of the acoustic output device 100 may be effectively improved. In some embodiments, ensuring the sound quality of the acoustic output device 100, reducing the higher order modes (or vibration modes) of the acoustic output device 100 in the audible range of the human ear, and increasing a flat curve range in the frequency response curve of the acoustic output device 100 may be achieved by reducing a size of the attachment area between the piezoelectric element 120 and the first position of the beam structure along the length direction of the beam structure. In some embodiments, the size of the attachment area between the piezoelectric element 120 and the first position of the beam structure along the length direction of the beam structure may be within a range of 1 mm to 50 mm. In some embodiments, the size of the attachment area between the piezoelectric element 120 and the first position of the beam structure along the length direction of the beam structure may be within a range of 1 mm to 45 mm. In some embodiments, the size of the attachment area between the piezoelectric element 120 and the first position of the beam structure along the length direction of the beam structure may be within a range of 2 mm to 40 mm. In some embodiments, the size of the attachment area between the piezoelectric element 120 and the first position of the beam structure along the length direction of the beam structure may be within a range of 3 mm to 30 mm. In some embodiments, the size of the attachment area between the piezoelectric element 120 and the first position of the beam structure along the length direction of the beam structure may be within a range of 5 mm to 20 mm.

In some embodiments, the size of the attachment area between the piezoelectric element 120 and the first position of the beam structure along the length direction of the beam structure may not exceed 80% of the size of the beam structure along the length direction. In some embodiments, the size of the attachment area between the piezoelectric element 120 and the first position of the beam structure along the length direction of the beam structure may not exceed 70% of the size of the beam structure along the length direction. In some embodiments, the size of the attachment area between the piezoelectric element 120 and the first position of the beam structure along the length direction of the beam structure may not exceed 60% of the size of the beam structure along the length direction. In some embodiments, the size of the attachment area between the piezoelectric element 120 and the first position of the beam structure along the length direction of the beam structure may not exceed 50% of the size of the beam structure along the length direction.

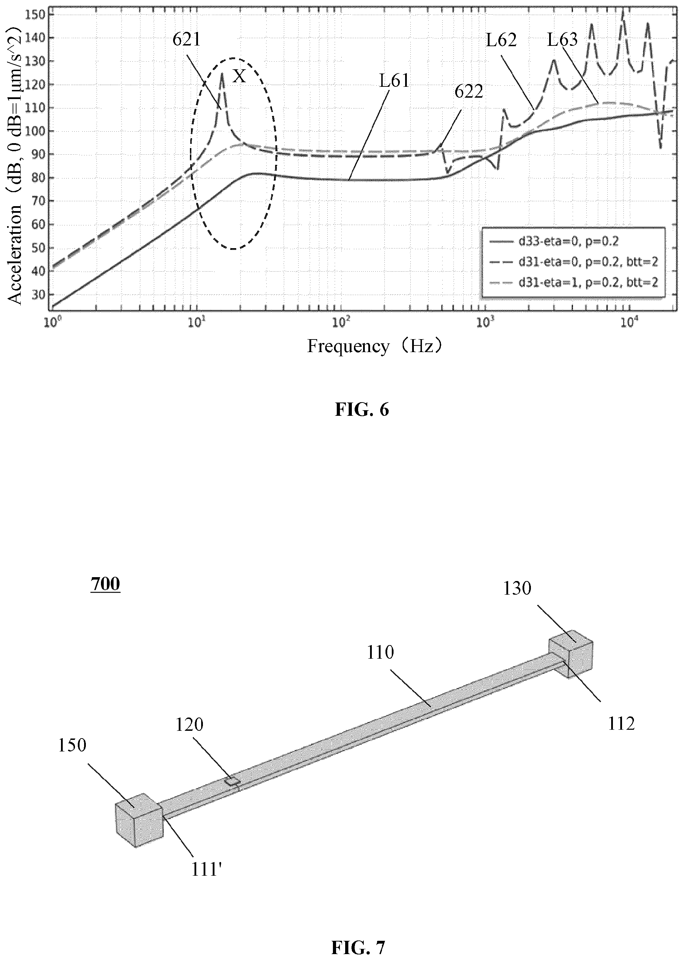

In some embodiments, by attaching a damping to one or more elements of the acoustic output device 100 to increase a damping coefficient of the acoustic output device 100, the sound quality of the acoustic output device 100 may also be improved, thereby making the frequency response curve of the acoustic output device 100 smoother in the audible range of the human ear (e.g., curve L63 shown in FIG. 6). For example, a material (e.g., silicone, rubber, foam, etc.) having a damping effect may be used to prepare the vibration element 110. As another example, a damping material may be coated on the piezoelectric element 120. As another example, the vibration element 110 and/or the mass element 130 may be filled with the damping material or an electromagnetic damping.

In some embodiments, the vibration element 110 may also be in a form of a sheet structure, a rod structure, etc. In some embodiments, a material of the vibration element 110 may be a material that has an ability to transmit the vibration. For example, the material of the vibration element 110 may be silicone, foam, plastic, rubber, metal, etc., or any combination thereof. In some embodiments, the vibration element 110 may be an element that has a good elasticity (i.e., an element is susceptible to elastic deformation). For example, the vibration element 110 may include a spring (e.g., an air spring, a mechanical spring, an electromagnetic spring, etc.), a vibration plate, an elastic sheet, a substrate, etc., or any combination thereof.

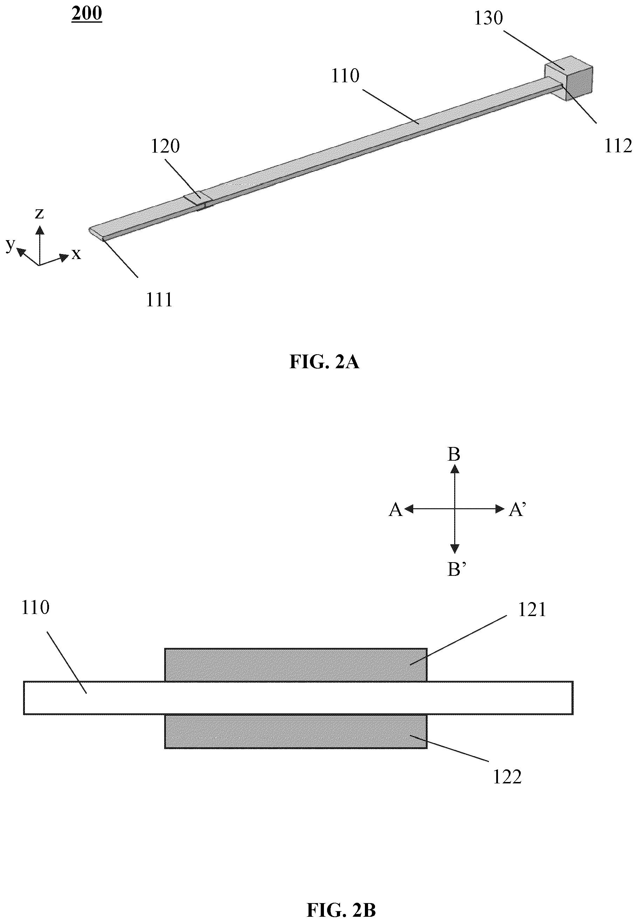

The piezoelectric element 120 may be an electrical energy conversion device capable of converting electrical energy into mechanical energy using the inverse piezoelectric effect. In some embodiments, the piezoelectric element 120 may be composed of materials having the piezoelectric effect (the inverse piezoelectric effect) such as piezoelectric ceramics, piezoelectric quartz, piezoelectric crystals, piezoelectric polymers, etc. In some embodiments, the piezoelectric element 120 may be in the shape of a sheet, a ring, a prism, a cube, a column, a ball, etc., or any combination thereof, or other irregular shapes. In some embodiments, the piezoelectric element 120 may have a beam structure, a sheet structure, or a block structure along the length direction of the piezoelectric element 120, etc. In some embodiments, the piezoelectric element 120 and the vibration element 110 may be beam structures having the same width. In some embodiments, the piezoelectric element 120 may be a monolithic structure. The piezoelectric element 120 is disposed on one side of the vibration element 110, and when the piezoelectric element 120 deforms along a polarization direction of the piezoelectric element 120, the piezoelectric element 120 may drive the vibration element 110 to vibrate in a same direction, i.e., the piezoelectric element 120 may be in the d33 operation mode. In some embodiments, the piezoelectric element 120 may include two piezoelectric sheets attached to opposite sides of the vibration element, respectively. When the piezoelectric element 120 deforms along a direction perpendicular to the polarization direction of the piezoelectric element 120, the vibration element 110 may produce the vibration along the polarization direction of the piezoelectric element 120 based on deformations of the two piezoelectric sheets, i.e., the piezoelectric element 120 may be in the d31 operation mode. More descriptions regarding the piezoelectric element 120 may be found in FIG. 2A, FIG. 2B and their descriptions.

The mass element 130 may be a mass block having a specific mass. In some embodiments, the mass element 130 may include a vibrating plate, a diaphragm, etc., to allow the acoustic output device 100 to output the vibration through the mass element 130. In some embodiments, a material of the mass element 130 may include, but is not limited to, a metal (e.g., copper, iron, magnesium, aluminum, tungsten, etc.), an alloy (aluminum alloy, titanium alloy, tungsten alloy, etc.), a polymeric material (e.g., PTFE, silicone rubber, etc.), and other materials.

The piezoelectric element 120 may deform in response to a driving voltage (or an electrical signal). The deformation may drive the vibration element 110 to vibrate, thereby driving the mass element 130 to vibrate. In some embodiments, the vibration element 110 and the mass element 130 may resonate to produce a first resonance peak (e.g., the first resonance peak 621 shown in FIG. 6).

In some embodiments, a resonance frequency corresponding to the first resonance peak generated by the resonance of the vibration element 110 and the mass element 130 may be determined according to equation (1):

$$f_0 = \frac{1}{2\pi}\sqrt{\frac{k}{m}}, (1)$$

where $f_0$ denotes the resonance frequency, $k$ denotes an elasticity coefficient of the vibration element 110, and $m$ denotes the mass of the mass element 130.

In some embodiments, it is known according to equation (1) that a frequency range of the resonance frequency corresponding to the first resonance peak may be adjusted by adjusting the mass of the mass element 130 and/or the elasticity coefficient of the vibration element 110. In some embodiments, the frequency of the first resonance peak may be within a range of 50 Hz to 2000 Hz. In some embodiments, the frequency of the first resonance peak may be within a range of 50 Hz to 1500 Hz. In some embodiments, the frequency of the first resonance peak may be within a range of 100 Hz to 1000 Hz. In some embodiments, the frequency of the first resonance peak may be within a range of 150 Hz to 500 Hz. In some embodiments, the frequency of the first resonance peak may be within a range of 150 Hz to 200 Hz.

In some embodiments, the vibration of the vibration element 110 with the mass element 130 may have a second resonance peak (e.g., the second resonance peak 622 shown in FIG. 6). In some embodiments, the second resonance peak may be generated by the resonance of the vibration element 110 and the mass element 130 (e.g., a higher order resonance compared to the resonance that produces the first resonance peak). In some embodiments, a ratio of the frequency of the second resonance peak to the frequency of the first resonance peak may be greater than 5. For example, the frequency of the first resonance peak may be within a range of 50 Hz to 200 Hz, and the frequency of the second resonance peak may be within a range of 500 Hz to 2000 Hz. As another example, the frequency of the first resonance peak may be within a range of 100 Hz and 500 Hz, and the frequency of the second resonance peak may be within a range of 500 Hz and 5000 Hz. As another example, the frequency of the first resonance peak may be within a range of 100 Hz to 1000 Hz, and the frequency of the second resonance peak may be within a range of 600 Hz to 20,000 Hz. As another example, the frequency of the first resonance peak may be within a range of 100 Hz to 2000 Hz, and the frequency of the second resonance peak may be within a range of 800 Hz to 20,000 Hz. In some embodiments, between the first resonance peak and the second resonance peak, the vibration of the vibration element 110 and the mass element 130 may produce at least one resonance valley. In some embodiments, an amplitude difference between the first resonance peak or the second resonance peak and the at least one resonance valley may be less than a predetermined threshold. For example, the amplitude difference between the first resonance peak or the second resonance peak and the at least one resonance valley may be less than 200 dB. As another example, the amplitude difference between the first resonance peak or the second resonance peak and the at least one resonance valley may be less than 150 dB. As another example, the amplitude difference between the first resonance peak or the second resonance peak and the at least one resonance valley may be less than 80 dB. As another example, the amplitude difference between the first resonance peak or the second resonance peak and the at least one resonance valley may be less than 50 dB. As another example, the amplitude difference between the first resonance peak or the second resonance peak and the at least one resonance valley may be less than 30 dB. In some embodiments, if the amplitude difference between the first resonance peak or the second resonance peak and the at least one resonance valley is less than the predetermined threshold, a flatter frequency response curve may be obtained between the first resonance peak and the second resonance peak, thereby improving the sound quality of the acoustic output device 100.

In some embodiments, by adjusting a length of the vibration element 110 (the beam structure) to adjust an elasticity coefficient of the vibration element 120, the frequency range of the resonance frequency corresponding to the first resonance peak may be adjusted. For example, the greater the length of the beam structure, the smaller the elasticity coefficient of the beam structure, and the lower the resonance frequency corresponding to the first resonance peak when the mass of the mass element 130 is specific. However, if the length of the beam structure is too long, it will be detrimental to the miniaturized design of the acoustic output device 100. In order to ensure that the acoustic output device 100 can produce the first resonance peak in a low frequency band, thereby improving the sensitivity in the frequency band and achieving device miniaturization, in some embodiments, the length of the beam structure may be less than 20 mm. In some embodiments, the length of the beam structure may be less than 30 mm. In some embodiments, the length of the beam structure may be less than 40 mm. In some embodiments, the length of the beam structure may be less than 50 mm. In some embodiments, the length of the beam structure may be less than 60 mm.

In some embodiments, by adjusting the mass of the mass element 130, the frequency range of the resonance frequency corresponding to the first resonance peak may be adjusted. For example, when the length of the beam structure is specific, the larger the mass of the mass element 130, the smaller the resonance frequency corresponding to the first resonance peak. However, if the mass of the mass element 130 is too large, it will be detrimental to the miniaturized design of the acoustic output device 100. In order to ensure that the acoustic output device 100 can produce the first resonance peak in a low frequency band, thereby improving the sensitivity in the frequency band and achieving device miniaturization, in some embodiments, the mass of the mass element 130 may be less than 5 g. In some embodiments, the mass of the mass element 130 may be less than 6 g. In some embodiments, the mass of the mass element 130 may be less than 8 g. In some embodiments, the mass of the mass element 130 may be less than 10 g.

In some embodiments, the vibration of the vibration element 110 (the acoustic output device 100) may be transmitted to a user in a bone conduction manner through the mass element 130. Merely as an exemplary illustration, the vibration of the vibration element 110 is transmitted to the bones and/or muscles of the face of the user through the mass element 130, and transmitted ultimately to the ear of the user. As another example, the mass element 130 may not be direct contact the human body, and the vibration of the vibration element 110 may be transmitted to the housing of the acoustic output device through the mass element 130, and then transmitted to the bones and/or muscles of the face of the user, and transmitted ultimately to the ear of the user. In some embodiments, the vibration of the vibration element 110 may also be transmitted to the user by air conduction through the mass element 130. Exemplarily, the mass element 130 may directly drive the air around it to vibrate, such that the vibration of the mass element 130 is transmitted to the ear of the user through the air. As another example, the mass element 130 may be further attached to a diaphragm, and the vibration of mass element 130 may be transmitted to the diaphragm, which in turn may drive the air to vibrate, such that the vibration of the mass element 130 is transmitted to the ear of the user through the air.

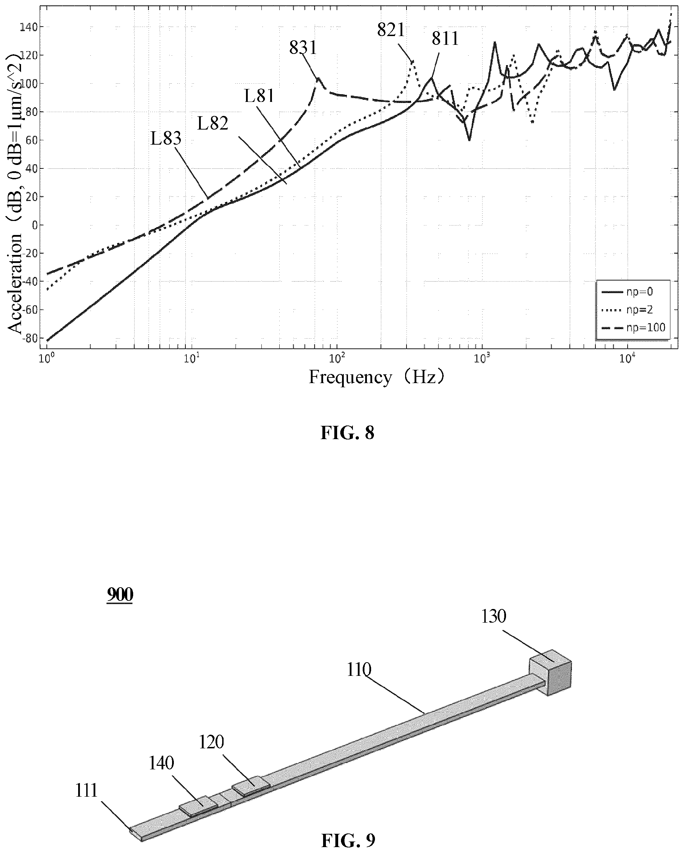

In some embodiments, the acoustic output device 100 may also include a second piezoelectric element 140. The second piezoelectric element 140 may have a similar structure, material, etc., as the piezoelectric element 120 (or referred to as a first piezoelectric element 120). The second piezoelectric element 140 is attached to a third position of the beam structure, and the piezoelectric element 120 and the second piezoelectric element 140 may be spaced apart along the length direction of the vibration element. Signals input by the piezoelectric element 120 and the second piezoelectric element 140 are the same, such that the piezoelectric element 120 and the second piezoelectric element 140 may be viewed as being connected in series. In some embodiments, the piezoelectric element 120 and the second piezoelectric element 140 may be in the d31 operation mode, and the deformation direction of the piezoelectric element 120 and the second piezoelectric element 140 may be perpendicular to a vibration direction of the vibration element 110. For example, the piezoelectric element 120 and the second piezoelectric element 140 deform reciprocally along a direction perpendicular to the polarization direction, and drive the vibration element 110 to vibrate in the polarization direction. In some embodiments, the beam structure may include a fixing end and a free end (i.e., the vibration element 110 is a cantilever beam structure). The fixing end may be fixed to other elements of the acoustic output device 100 (e.g., on an inner wall of a housing) and the free end may be connected to the mass element 130. In some embodiments, the higher order modes generated during vibration of the vibration element 110 and the mass element 130 may be reduced or eliminated by adjusting the spacing of the piezoelectric element 120 and the second piezoelectric element 140 along the length direction of the beam structure. For example, the resonance peaks (or resonance valleys) generated by the vibration of the vibration element 110 and the mass element 130 driven by the piezoelectric element 120 in a mid-to-high frequency band (e.g., 500 Hz to 2000 Hz) may be merged with the resonance valleys (or the resonance valleys) generated by the vibration of the vibration element 110 and the mass element 130 driven by the second piezoelectric element 140 in the mid-to-high frequency band (e.g., 500 Hz to 2000 Hz) ), thereby eliminating the higher order modes of the acoustic output device 100 in the mid-to-high frequency band, making the frequency response curve smoother, and ensuring that the sound quality of the acoustic output device 100 can be improved. In some embodiments, the resonance valleys and the resonance peaks that can be merged may refer to resonance valleys and resonance peaks having similar or identical frequencies. More descriptions regarding the second piezoelectric element 140 of the acoustic output device 100 may be found in FIG. 9 and its related descriptions, which will not be repeated herein.

In some embodiments, the acoustic output device 100 may further include a second mass element 150, wherein the mass element 130 (also referred to as the first mass element 130) and the second mass element 150 may be located on both sides of the piezoelectric element 120 along the length direction of the vibration element 110. In some embodiments, the beam structure may be tended to be fixed on one side of the second mass element 150 (i.e., equivalent to the fixing end mentioned above) by making the mass of the second mass element 150 larger than the mass of mass element 130, thereby solving a problem that the fixing end of the beam structure is difficult to find a fixed boundary in the acoustic output device 100 (e.g., the housing) and is not well fixed. In some embodiments, an adjustment of the resonance frequency corresponding to the first resonance peak may be achieved by adjusting a ratio of the mass of the second mass element 150 to the mass of the mass element 130. More descriptions regarding the second mass element 150 of the acoustic output device 100 may be found in FIG. 7 and its related descriptions, which will not be repeated herein.

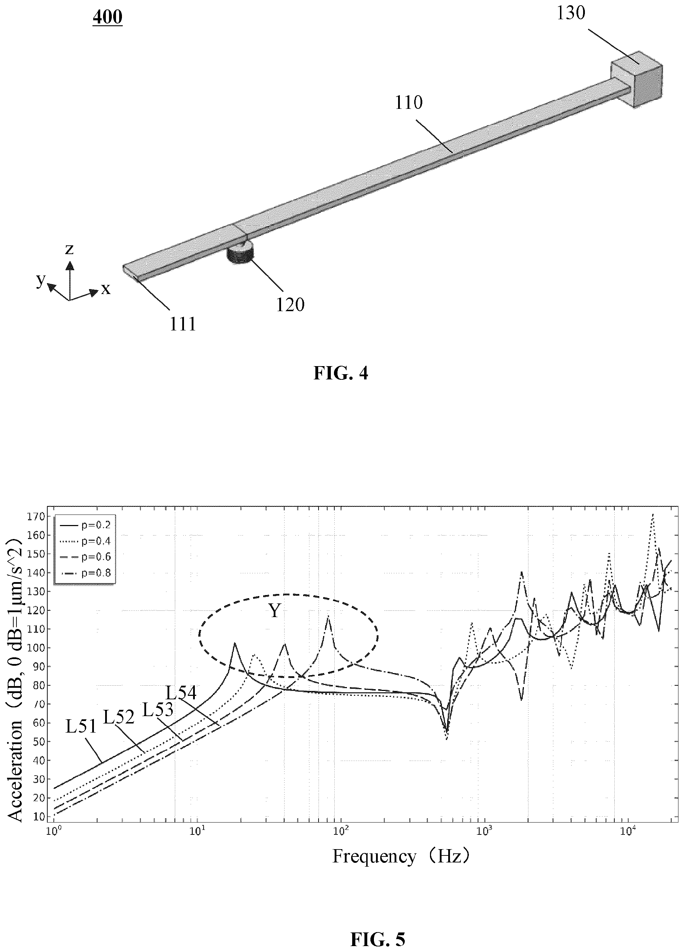

In some embodiments, the piezoelectric element 120 may be in the d33 operation mode, and the deformation direction of the piezoelectric element 120 may be parallel to the vibration direction of the vibration element 110. For example, when the piezoelectric element 120 deforms along the polarization direction of the piezoelectric element 120, the deformation of the piezoelectric element 120 may also drive the vibration element 110 to vibrate along the polarization direction. In some embodiments, one end of the piezoelectric element 120 along the vibration direction is fixed (e.g., fixed to other elements of the acoustic output device 100, e.g., the housing) and another end of the piezoelectric element 120 is connected to the beam structure (e.g., attached to the beam structure) at the first position. In some embodiments, the resonance frequency corresponding to the resonance peak of the acoustic output device 100 in the low frequency band may be adjusted by adjusting a position of the piezoelectric element 120 on the beam structure, for example, by adjusting a ratio of a distance from the first position to the fixing end of the beam structure to the length of the beam structure. Thus, the sensitivity of the acoustic output device 100 may be increased in different frequency bands for applying to more use scenarios. More descriptions regarding the deformation direction of the piezoelectric element 120 of the acoustic output device 100 being parallel to the vibration direction of the vibration element 110 may be referred to FIG. 4 and its related descriptions, which will not be repeated herein.

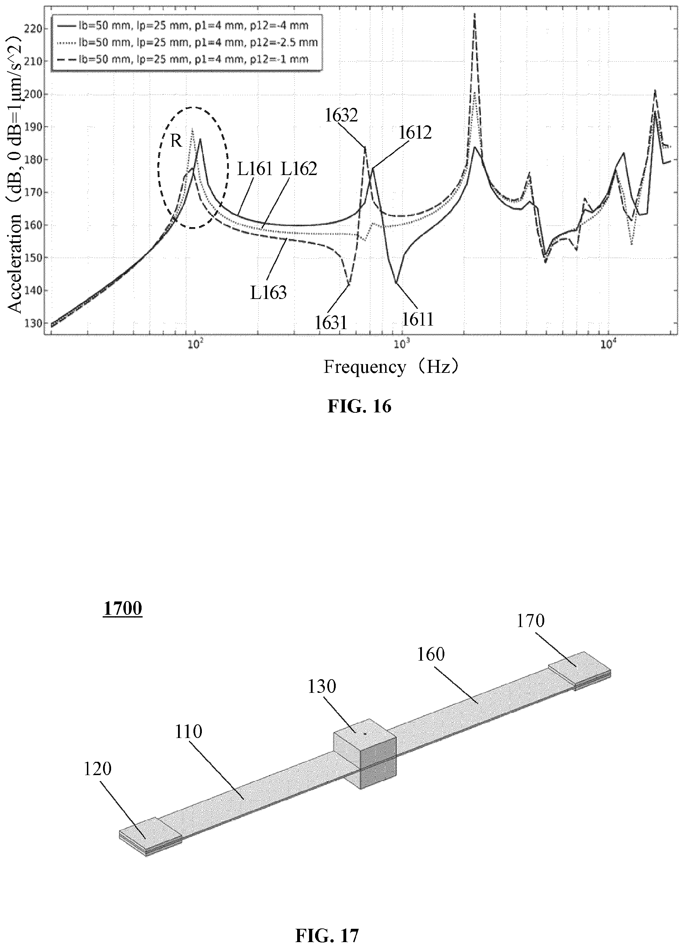

In some embodiments, the acoustic output device 100 may further include a second vibration element 160, and the vibration element 110 (also referred to as the first vibration element 110) and the second vibration element 160 are provided respectively on either side of the mass element 130. The vibration element 110 and the second vibration element 160 are respectively provided at one end away from the mass element 130. In some embodiments, the acoustic output device 100 may include a third piezoelectric element 170 connected to the second vibration element 160. The third piezoelectric element 170 is provided symmetrically with the piezoelectric element 120 on both sides of the mass element 130, such that the third piezoelectric element 170 may be viewed as being connected in parallel with the piezoelectric element 120. By setting in this way, the resonance valley of the frequency response curve of the acoustic output device 100 in the audible range of the human ear may be reduced or eliminated to ensure that the frequency response curve is relatively smoother and the sound quality of the acoustic output device 100 is relatively better. More descriptions regarding the acoustic output device also including the second vibration element 160 and the third piezoelectric element 170 may be found in FIG. 17 and its related descriptions, which will not be repeated herein.

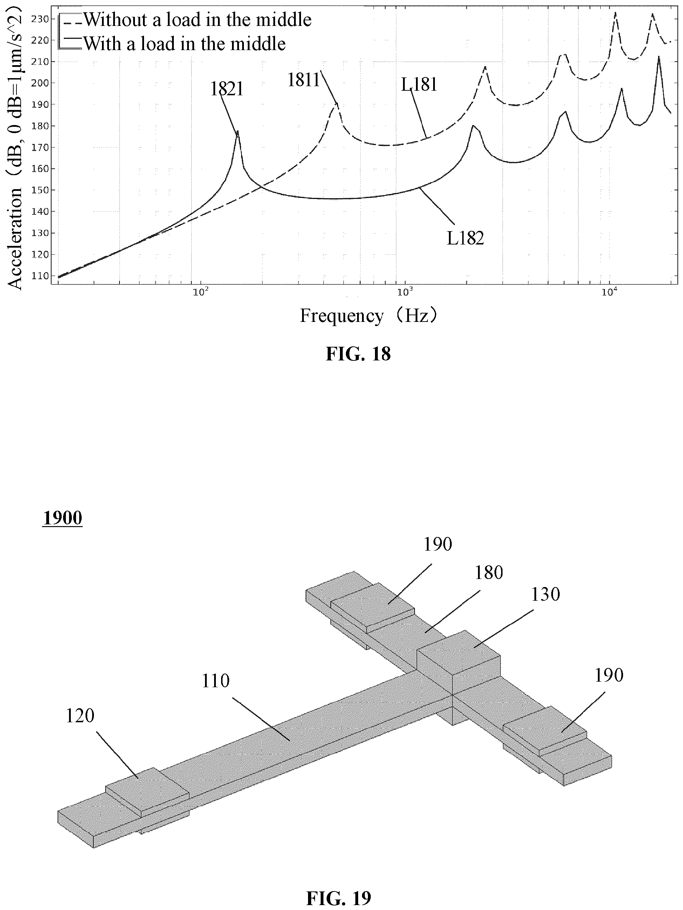

In some embodiments, the acoustic output device 100 may include a third vibration element 180 connected to the mass element 130. In some embodiments, a ratio of a length of the third vibration element 180 to a length of the vibration element 110 may be greater than 0.7, and a vibration direction of the third vibration element 180 is parallel to the vibration direction of the vibration element 110. In some embodiments, the acoustic output device 100 may further include a fourth piezoelectric element 190 connected to the third vibration element 180. The fourth piezoelectric element 190 is in the d31 operation mode, a deformation direction of the fourth piezoelectric element 190 is perpendicular to the vibration direction of the third vibration element 180. Therefore, a resonance peak in the low frequency band generated by a vibration of the third vibration element 180 and the mass element 130 may supplement the resonance valley generated by the vibration of the vibration element 110 and the mass element 110, thereby making the frequency response curve of the acoustic output device 100 smoother and the sound quality better. In addition, the third vibration element 180 may increase a vibration amplitude of the mass element 130 in the low frequency band, thereby improving the sensitivity of the acoustic output device 100 in the low frequency band. More descriptions regarding the acoustic output device including the third vibration element 180 and the fourth piezoelectric element 190 may be found in FIG. 19 and its related descriptions, which will not be repeated herein.

In some embodiments, the acoustic output device 100 may also include a housing structure 210. The housing structure 210 may be configured to carry other elements of the acoustic output device 100 (e.g., the vibration element 110, the second vibration element 160, the third vibration element 180, the piezoelectric element 120, the second piezoelectric element 140, the third piezoelectric element 170, the fourth piezoelectric element 190, the mass element 130, the second mass element 150, etc., or any combination thereof). In some embodiments, the housing structure 210 may be an enclosed or semi-enclosed structure that is hollow inside, and other elements of the acoustic output device 100 are located in or on the housing structure. In some embodiments, a shape of the housing structure may be a three-dimensional structure with a regular or irregular shape such as a rectangle, a cylinder, a round table, etc. The housing structure may be located close to the ear of the user when the user wears the acoustic output device 100. For example, the housing structure may be located on one circumferential side of the ear of the user (e.g., a front side or a back side). As another example, the housing structure may be located at a position of the ear of the user that not blocks or covers the ear canal of the user. In some embodiments, the acoustic output device 100 may be a bone conduction headphone, where at least one side of the housing structure may be in contact with the skin of the user. An acoustic driver assembly (e.g., the combination of the piezoelectric element 120, the vibration element 110, and the mass element 130) in the bone conduction headphone converts an audio signal into a mechanical vibration that may be transmitted to the auditory nerve of the user through the housing structure and the bones of the user. In some embodiments, the acoustic output device 100 may be an air conduction headphone, and at least one side of the housing structure may or may not be in contact with the skin of the user. A side wall of the housing structure includes at least one sound conduction hole, and the acoustic driver assembly of the air conduction headphone converts an audio signal into an air conduction sound that may be radiated in a direction of the ear of the user through the sound conduction hole.

In some embodiments, the acoustic output device 100 may include a fixing structure 220. The fixing structure 220 may be configured to elevate the acoustic output device 100 close to the ear of the user. In some embodiments, the fixing structure 220 may be physically connected (e.g., glued, snapped, threaded, etc.) to the housing structure 210 of the acoustic output device 100. In some embodiments, the housing structure 210 of the acoustic output device 100 may be a portion of the fixing structure 220. In some embodiments, the fixing structure 220 may include an ear hook, a rear hook, an elastic band, eyeglass legs, etc., to allow the acoustic output device 100 to be more fixedly erected at a position close to the ear of the user, thereby preventing the user from dropping it during use. For example, the fixing structure 220 may be an ear hook configured to be worn around an ear area. In some embodiments, the ear hook may be a continuous hook and elastically stretched to be worn at the ear of the user. At the same time, the ear hook may also exert pressure on the auricle of the user, thereby causing the acoustic output device 100 to be securely fixed to a specific location on the ear or head of the user. In some embodiments, the ear hook may be a discontinuous band. For example, the ear hook may include a rigid portion and a flexible portion. The rigid portion may be made of a rigid material (e.g., plastic or metal) fixed to the housing structure 210 of the acoustic output device 100 through the physical connection (e.g., the clamping connection, the threaded connection, etc.). The flexible portion may be made of an elastic material (e.g., fabric, composite material, or/and neoprene). As another example, the fixing structure 220 may be a neck band configured to be worn around a neck/shoulder area. As another example, the fixing structure 220 may be eyeglass legs which, as a portion of the glasses, are mounted on the ear of the user.

It should be noted that the above descriptions of FIG. 1 are merely provided for the purposes of illustration, and are not intended to limit the scope of the present disclosure. For those skilled in the art, various amendments and variations may be made according to the teachings of the present disclosure. For example, in some embodiments, the acoustic output device 100 may also include one or more elements (e.g., a signal transceiver, an interaction module, a battery, etc.). In some embodiments, one or more elements of the acoustic output device 100 may be replaced by other elements that may perform similar functions. For example, the acoustic output device 100 may not include the fixing structure 220, and the housing structure 210 or a portion thereof may be a housing structure having a shape adapted to the human ear (e.g., circular, elliptical, polygonal (regular or irregular), U-shaped, V-shaped, semicircular), so that the housing structure may be hooked up near to the ear of the user. These amendments and variations do not depart from the scope of the present disclosure.

FIG. 2A is a schematic diagram illustrating a structure of an acoustic output device according to some embodiments of the present disclosure.

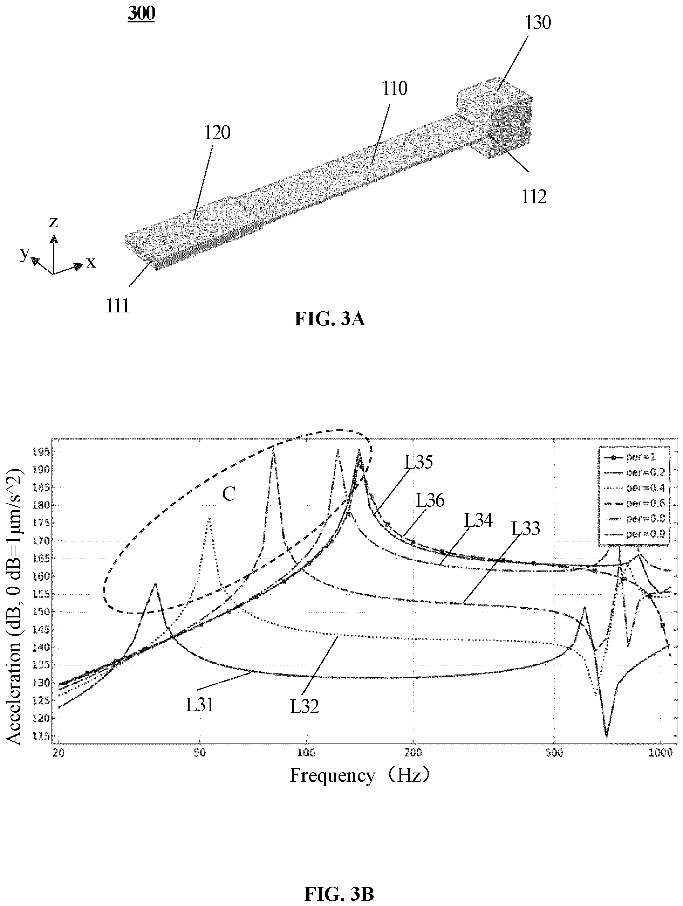

As shown in FIG. 2A, an acoustic output device 200 may include a vibration element 110, a piezoelectric element 120, and a mass element 130. The vibration element 110 has a beam structure along the length direction (i.e., X-direction) of the vibration element 110. The piezoelectric element 120 may be attached to a first position of the beam structure, and the mass element 130 may be attached to a free end 112 (i.e., a second position) of the beam structure. The first position and the second position are spaced apart along the length direction of the beam structure. In some embodiments, the first position may be located at any position along the length direction of the beam structure. For example, the first position may be located at the center of the length direction of the beam structure. As another example, the piezoelectric element 120 may cover the beam structure along the length direction of the beam structure, i.e., the first position may cover the beam structure. In some embodiments, the actual contact surface between the piezoelectric element 120 and the beam structure may be referred to as the attachment area of the piezoelectric element 120. In some embodiments, a resonance frequency and an amplitude corresponding to a resonance peak generated by the acoustic output device 200 in the low frequency band may be adjusted by adjusting the size of the attachment area of the piezoelectric element 120 along the length direction of the beam structure, so as to adapt to more scenarios and to improve a sensitivity of the acoustic output device 200 in the low frequency band. More descriptions of adjusting the size of the attachment area of the piezoelectric element 120 may be found in FIG. 3A, FIG. 3B and their related descriptions, which will not be repeated herein.

In some embodiments, the vibration element 110 may have a cantilever beam structure. The cantilever beam structure has a fixing end 111 and a free end 112. The fixing end 111 may be fixed to other elements of the acoustic output device 100 (e.g., on the inner wall of the housing), and the free end 112 may be connected to the mass element 130 to output the vibration. The piezoelectric element 120 may drive the vibration element 110 and the mass element 130 to vibrate along a polarization direction (i.e., Z-direction) of the piezoelectric element 120, so that the vibration element 110 and the mass element 130 can produce a first resonance peak (or may be referred to as a low frequency peak) in a low frequency band (e.g., 50 Hz to 2000 Hz), thereby improving a sensitivity of the acoustic output device 200 in the low frequency band.

In some embodiments, as shown in FIG. 2A, the beam structure (or cantilever beam) may be a rectangular structure. The rectangular structure may have a length along the X-direction, a width along the Y-direction, and a thickness along the Z-direction. It should be noted that the rectangular beam structure shown in FIG. 2A is merely provided for the purposes of illustration, and is not intended to limit the scope of the present disclosure. For those skilled in the art, various amendments and variations may be made according to the teachings of the present disclosure. In some embodiments, the structure, the size, and material parameters of the beam structure, or at least a portion thereof may be adjusted. For example, the beam structure in the present disclosure may not be limited to the rectangular structure described above, but may also be other shapes, e.g., a cross-sectional shape of the beam structure along the length direction (i.e., X-direction) may be triangular, semi-circular, rhombic, pentagonal, hexagonal, or other regular or irregular shapes. As another example, the width and/or thickness at different locations on the beam structure may be the same or different. As another example, the shapes at different locations on the beam structure may be the same or different.

FIG. 2B is a schematic diagram illustrating a cross-section view of the acoustic output device shown in FIG.

2A perpendicular to a length direction of a vibration element (i.e., Y-direction).

In some embodiments, the deformation direction of the piezoelectric element 120 in the acoustic output device 200 may be parallel to the length direction of the vibration element 110, thereby driving the vibration element 110 to produce the vibration along the polarization direction of the piezoelectric element 120, i.e., the vibration direction of the vibration element 110 may be parallel to the polarization direction of the piezoelectric element 120. Specifically, as shown in FIG. 2B, the piezoelectric element 120 may include two piezoelectric sheets (i.e., a piezoelectric sheet 121 and a piezoelectric sheet 122). The piezoelectric sheet 121 and the piezoelectric sheet 122 may be attached to opposite sides of the vibration element 110 (at the first position of the vibration element 110), respectively, with the polarization direction of the piezoelectric sheet 121 and the piezoelectric sheet 122 perpendicular to the attachment surface. The vibration element 110 may vibrate along a direction perpendicular to the attachment surface in response to the deformation of the piezoelectric sheet 121 and the piezoelectric sheet 122.

In some embodiments, the piezoelectric sheet 121 and the piezoelectric sheet 122 may be assemblies configured to provide the piezoelectric effect and/or the inverse piezoelectric effect. In some embodiments, the piezoelectric sheet(s) may cover one or more surfaces of the vibration element 110 and deform in response to a driving voltage to drive the vibration element 110 to warp, thereby allowing the piezoelectric element 120 to output the vibration. For example, along the polarization direction of the piezoelectric element 120 (as shown by arrow BB' in the figure), the piezoelectric sheet 121 and the piezoelectric sheet 122 are attached to the opposite sides of the vibration element 110, and the vibration element 110 may vibrate according to extensions and contractions of the piezoelectric sheet 121 and the piezoelectric sheet 122 along the length direction of the piezoelectric element 120 (as shown by arrow AA' in the figure) of the piezoelectric element 120. Specifically, the piezoelectric sheet located on one side of the vibration element 110 (e.g., the piezoelectric sheet 121) may contract along its length direction, and the piezoelectric sheet located on the other side of the vibration element 120 (e.g., the piezoelectric sheet 122) may extend along its length, thereby driving the vibration element 110 to warp in a direction perpendicular to its surface (i.e., the thickness direction BB') to produce the vibration. In some embodiments, the material of the piezoelectric sheet 121 and/or the piezoelectric sheet 122 may include piezoelectric ceramic, piezoelectric quartz, piezoelectric crystals, piezoelectric polymer, etc., or any combination thereof.

It is noted that the piezoelectric element 120 shown in FIG. 2B is merely provided for the purposes of illustration, and is not intended to limit the scope of the present disclosure. In some embodiments, a count of piezoelectric sheets of the piezoelectric element 120 may not be limited to the two shown in FIG. 2B. For example, the piezoelectric element 120 may include one piezoelectric sheet that is attached to the one side of the vibration element 110 (of the first position) and may deform in response to the driving voltage, thereby driving the vibration element 110 to warp and achieving the piezoelectric element 120 to output the vibration.

In some embodiments, a resonance frequency and an amplitude corresponding to the resonance peak generated by the acoustic output device in the low frequency band may be adjusted by adjusting the size of the attachment area of the piezoelectric element 120 along the length direction of the beam structure to accommodate more scenarios and to facilitate increasing the sensitivity of the acoustic output device in the low frequency band. Merely by way of example, FIG. 3A is a schematic diagram illustrating a structure of an acoustic output device according to some embodiments of the present disclosure. As shown in FIG. 3A, in an acoustic output device 300, the piezoelectric element 120 covers (is attached to) at least a portion of the beam structure (i.e., the vibration element 110) along the length direction of the beam structure starting from the fixing end 111. In some embodiments, a ratio of the size of the attachment area of the piezoelectric element 120 along the length direction of the beam structure to the length of the beam structure may affect the elasticity of the beam structure. For example, when a cross-sectional height along the length direction (i.e., X-direction) of the portion (referred to as a covered portion) of the beam structure where the piezoelectric element 120 is attached is greater than a cross-sectional height along the length direction of the portion (referred to as an uncovered portion) where the piezoelectric element 120 is not attached, a flexural modulus of the covered portion is greater than a flexural modulus of the uncovered portion, that is, an elasticity coefficient of the covered portion is higher than an elasticity coefficient of the uncovered portion, which is shown as being less prone to bending. In some embodiments, as the ratio of the size of the attachment area of the piezoelectric element 120 along the length direction of the beam structure to the length of the beam structure increases, the elasticity coefficient of the entire beam structure increases, which causes the resonance frequency corresponding to the low frequency peak in the frequency response curve of the acoustic output device 300 to increase.

FIG. 3B is a schematic diagram illustrating frequency response curves of acoustic output devices according to some embodiments of the present disclosure. As shown in FIG. 3B, curve L31 is a frequency response curve when a ratio (denoted by per in FIG. 3B) of the size of the attachment area of the piezoelectric element 120 of the acoustic output device 300 along the length direction of the beam structure to the length of the beam structure is 0.2. Curve L32 is a frequency response curve when a ratio of the size of the attachment area of the piezoelectric element 120 of the acoustic output device 300 along the length direction of the beam structure to the length of the beam structure is 0.4. Curve L33 is a frequency response curve when a ratio of the size of the attachment area of the piezoelectric element

EP 4 294 049 A1

120 of the acoustic output device 300 along the length direction of the beam structure to the length of the beam structure is 0.6. Curve L34 is a frequency response curve when a ratio of the size of the attachment area of the piezoelectric element 120 of the acoustic output device 300 along the length direction of the beam structure to the length of the beam structure is 0.8. Curve L35 is a frequency response curve when a ratio of the size of the attachment area of the piezoelectric element 120 of the acoustic output device 300 along the length direction of the beam structure to the length of the beam structure is 0.9. Curve L36 is a frequency response curve when a ratio of the size of the attachment area of the piezoelectric element 120 of the acoustic output device 300 along the length direction of the beam structure to the length of the beam structure is 1. Resonance peaks in dotted circle C are the first resonance peaks generated by the acoustic output device 300 in the low frequency band when the ratio of the size of the attachment area of the piezoelectric element 120 of the acoustic output device 300 along the length direction of the beam structure to the length of the beam structure is different.

As may be seen from FIG. 3B, as the ratio of the size of the attachment area of the piezoelectric element 120 along the length direction of the beam structure to the length of the beam structure increases, the resonance frequency corresponding to the first resonance peak of the acoustic output device (e.g., the acoustic output device 300) in the low frequency band gradually increases (e.g., the resonance frequencies corresponding to the first resonance peaks in curves L31-L36 gradually increases). When the ratio of the size of the attachment area of the piezoelectric element 120 along the length direction of the beam structure to the length of the beam structure reaches 90%, the resonance frequency corresponding to the first resonance peak in curve L35 is almost the same as the resonance frequency corresponding to the first resonance peak in curve L36. When the ratio of the size of the attachment area of the piezoelectric element 120 along the length direction of the beam structure to the length of the beam structure is equal to or less than 80%, the resonant frequencies corresponding to the first resonance peaks in curves L34, curve L33, curve L32, and curve L31 decrease with a decrease of the ratio. In order to ensure that the acoustic output device (e.g., the acoustic output device 300) can produce a resonance peak in a relatively low frequency band (i.e., the first resonance peak), thereby achieving a purpose of improving the sensitivity of the acoustic output device in the low frequency band, in some embodiments, the size of the attachment area of the piezoelectric element 120 along the length direction of the beam structure may not exceed 80% of the size of the beam structure along the length direction. In some embodiments, the size of the attachment area of the piezoelectric element 120 along the length direction of the beam structure may not exceed 60% of the size of the beam structure along the length direction. In some embodiments, the size of the attachment area of the piezoelectric element 120 along the length direction of the beam structure may not exceed 50% of the size of the beam structure along the length direction. In some embodiments, the size of the attachment area of the piezoelectric element 120 along the length direction of the beam structure may not exceed 40% of the size of the beam structure along the length direction.

In addition, it can also be seen from FIG. 3B that as the ratio of the size of the attachment area of the piezoelectric element 120 along the length direction of the beam structure to the length of the beam structure decreases, peak values corresponding to the first resonance peaks in curves L36-L31 decrease, which is because the size of the piezoelectric element 120 along the length direction of the beam structure decreases, resulting in a decrease in the output force of the piezoelectrical element 120 and a decrease in the peak value of the resonance peak. In order to ensure that the resonance peak of the acoustic output device in the low frequency band may have a higher peak value, thereby increasing the sensitivity in this band, in some embodiments, the size of the attachment area of the piezoelectric element 120 along the length direction of the beam structure may be greater than 5% of the size of the beam structure along the length. In some embodiments, the size of the attachment area of the piezoelectric element 120 along the length direction of the beam structure may be greater than 10% of the size of the beam structure along the length direction. In some embodiments, the size of the attachment area of the piezoelectric element 120 along the length direction of the beam structure may be greater than 20% of the size of the beam structure along the length direction. In some embodiments, the size of the attachment area of the piezoelectric element 120 along the length direction of the beam structure may be greater than 30% of the size of the beam structure along the length direction.

FIG. 4 is a schematic diagram illustrating a structure of an acoustic output device according to some embodiments of the present disclosure.

As shown in FIG. 4, an acoustic output device 400 may have a similar structure as the acoustic output device 200, and a difference between the acoustic output device 400 and the acoustic output device 200 is that a manner of set and the operation mode of the piezoelectric element 120 in the acoustic output device 400 is different from a manner of set and the operation mode of the piezoelectric element 120 in the acoustic output device 200. In the acoustic output device 400, the piezoelectric element 120 is in the d33 operation mode, and the deformation direction of the piezoelectric element 120 may be parallel to the vibration direction of the vibration element 110. Specifically, in the acoustic output device 400, the piezoelectric element 120 is attached to one side of the vibration element 110 along the vibration direction of the vibration element 110. Further, one end of the piezoelectric element 120 along the polarization direction is fixed, and another end of the piezoelectric element 120 is connected (attached) to the beam structure at the first position. By setting in this way, the piezoelectric element 120 may drive the vibration element 110 to vibrate along the same direction when the piezoelectric element 120 deforms along its polarization direction. In some embodiments, the piezoelectric element 120 may have a stacked structure. As an exemplary illustration, the piezoelectric element 120 may include a plurality of layers of piezoelectric sheets that may be stacked along the polarization direction of the piezoelectric sheets to form the piezoelectric element 120.

In some embodiments, along the length direction of the beam structure, a distance between the fixing end 111 and the piezoelectric element 120 (or the first position) varies, and a resonance frequency corresponding to a resonance peak of a frequency response curve of the acoustic output device 400 in a low frequency band varies. The first position here may refer to a position of an edge of the piezoelectric element 120 close to the fixing end 111. Therefore, the resonance frequency corresponding to the resonance peak of the frequency response curve of the acoustic output device 400 in the low frequency band may be changed by adjusting the distance between the fixing end 111 and the piezoelectric element 120 along the length direction of the beam structure, thereby facilitating a sensitivity enhancement of the acoustic output device in different frequency bands for applying to more scenarios. The following will be described in detail according to the frequency response curve of the acoustic output device.

FIG. 5 is a schematic diagram illustrating frequency response curves of acoustic output devices according to some embodiments of the present disclosure.

In FIG. 5, curve L51 is a frequency response curve when a ratio of the distance between the fixing end 111 and the piezoelectric element 120 of the acoustic output device 400 to the length of the beam structure (denoted by p in FIG. 5) is 0.2. Curve L52 is a frequency response curve when a ratio of the distance between the fixing end 111 and the piezoelectric element 120 of the acoustic output device 400 to the length of the beam structure is 0.4. Curve L53 is a frequency response curve when a ratio of the distance between the fixing end 111 and the piezoelectric element 120 of the acoustic output device 400 to the length of the beam structure is 0.6. Curve L54 is a frequency response curve when a ratio of the distance between the fixing end 111 and the piezoelectric element 120 of the acoustic output device 400 to the length of the beam structure is 0.8. The resonance peaks within a dotted circle Y are first resonance peaks generated by the acoustic output devices 400 in the low frequency band.

As can be seen from FIG. 5, when a distance between a piezoelectric element and a fixing end in an acoustic output device (e.g., the acoustic output device 400) increases, the resonance frequency corresponding to the resonance peak of the acoustic output device in the low frequency band also increases (e.g., the resonant frequencies corresponding to the resonance peaks in curves L51, curve L52, curve L53, and curve L54 gradually increase). In order to ensure that the acoustic output device (e.g., the acoustic output device 400) is capable of producing the first resonance peak in the low frequency band to increase the sensitivity in this band, in some embodiments, a ratio of the distance between the first position and the fixing end to the length of the beam structure may be less than 0.8. In some embodiments, a ratio of the distance between the first position and the fixing end to the length of the beam structure may be less than 0.6. In some embodiments, a ratio of the distance between the first position and the fixing end to the length of the beam structure may be less than 0.4.

FIG. 6 is a schematic diagram illustrating frequency response curves of acoustic output devices according to some embodiments of the present disclosure.

As shown in FIG. 6, curve L61 is a frequency response curve of an acoustic output device (e.g., the acoustic output device 400) when a damping coefficient (denoted by eta in FIG. 6) of the acoustic output device is 0, a ratio of a distance between a fixing end (e.g., the fixing end 111) and the piezoelectric element 120 of the acoustic output device to the length of the beam structure (denoted by p in FIG. 6) is 0.2, and the piezoelectric element 120 is in the d33 operation mode. Curve L62 is a frequency response curve of an acoustic output device (e.g., the acoustic output device 200) when a damping coefficient of the acoustic output device is 0, a ratio of a distance between a fixing end and the piezoelectric element 120 of the acoustic output device to the length of the beam structure is 0.2, the piezoelectric element 120 is in the d31 operation mode, and a width of the piezoelectric element 120 is 2 mm. Curve L63 is a frequency response curve of an acoustic output device (e.g., the acoustic output device 200) when a damping coefficient of the acoustic output device is 1, a ratio of a distance between a fixing end and the piezoelectric element 120 of the acoustic output device to the length of the beam structure is 0.2, the piezoelectric element 120 is in the d31 operation mode, and a width of the piezoelectric element 120 is 2 mm. In some embodiments, the width of the piezoelectric element 120 may be the same as the width of the beam structure. A first resonance peak (or low frequency peak) in the dotted circle X may be generated by the resonance of the vibration element 110 and the mass element 130. The first resonance peak facilitates increasing the sensitivity of the acoustic output device 200 in the low frequency band.

According to FIG. 6, in some embodiments, the vibration element 110 and mass element 130 may produce the first resonance peak within a range of 50 Hz to 2000 Hz. In some embodiments, the vibration element 110 and mass element 130 may produce the first resonance peak within a range of 100 Hz to 2000 Hz. In some embodiments, the vibration element 110 and the mass element 130 may produce the first resonance peak within a range of 200 Hz to 2000 Hz. In some embodiments, the vibration element 110 and the mass element 130 may produce the first resonance peak within a range of 500 Hz to 1500 Hz. In some embodiments, the vibration element 110 and the mass element 130 may produce the first resonance peak within a range of 500 Hz to 1000 Hz.

According to curve L61 and curve L62, it may be seen that compared with the piezoelectric element 120 in the d33 operation mode, when the piezoelectric element 120 is in the d31 operation mode, the acoustic output device may produce the first resonance peak with a higher peak value in the low frequency band. Therefore, in some embodiments, the sensitivity of the acoustic output device in the low frequency band may be improved by causing the piezoelectric element 120 to be in the d31 operation mode.

In some embodiments, a damping structure may be added to the acoustic output device to increase the damping coefficient of the acoustic output device to make the vibration response curve of the acoustic output device relatively smooth, thereby further improving the sound quality of the acoustic output device. For example, the vibration element 110 may be made of a damping material (e.g., nitrile). As another example, the damping material may be added to the vibration element 110, such as a damping coating applied to a surface of the vibration element 110 or penetrated into an interior of the vibration element 110. According to curve L62 and curve L63, L63 is smoother relative to L62, but a peak value of the first resonance peak of curve L61 is significantly smaller than a peak value of the first resonance peak of L63. Therefore, in some embodiments, the frequency response curve of the acoustic output device may be relatively flatter by appropriately increasing the damping coefficient of the acoustic output device, so that the acoustic output device has the relatively better sound quality. However, when the damping coefficient of the acoustic output device is too large, the peak value of the first resonance peak of the acoustic output device in the low frequency band decreases, such that the sensitivity of the acoustic output device in the low frequency band is reduced. In order to ensure that the acoustic output device has good sound quality and good sensitivity in the low frequency band, in some embodiments, a damping coefficient of the acoustic output device may be within a range of 0 to 1. In some embodiments, a damping coefficient of the acoustic output device may be within a range of 0 to 0.8. In some embodiments, a damping coefficient of the acoustic output device may be within a range of 0.1 to 0.7. In some embodiments, a damping coefficient of the acoustic output device may be within a range of 0.1 to 0.7. In some embodiments, a damping coefficient of the acoustic output device may be within a range of 0.2 to 0.5.

FIG. 7 is a schematic diagram illustrating a structure of an acoustic output device according to some embodiments of the present disclosure.

As shown in FIG. 7, a structure of an acoustic output device 700 may be seen as the structure of the acoustic output device 200 having some variations. Specifically, a difference between the acoustic output device 700 and the acoustic output device 200 is that the fixing end 111 in the acoustic output device 200 is arranged as a free end 111' in the acoustic output device 700, and in addition, the acoustic output device 700 may further include a second mass element 150. Along the length direction of the vibration element 110, the mass element 130 and the second mass element 150 may be located on both sides of the piezoelectric element 120. As an exemplary illustration, the mass element 130 and the second mass element 150 may be respectively connected to both ends of the length direction of the beam structure. For example, the second mass element 150 is connected to the free end 111', and the mass element 130 is connected to the free end 112.

In some embodiments, the masses of the mass element 130 and the second mass element 150 may be the same or different. As described in FIG. 1, the frequency range of the resonance frequency corresponding to the first resonance peak may be adjusted by adjusting the mass of the mass element 130. For a specific length of the beam structure, the larger the mass of the mass element 130, the smaller the resonance frequency corresponding to the first resonance peak. In some embodiments, the mass of the mass element 130 may be less than 5 g. In some embodiments, the mass of the mass element 130 may be less than 6 g. In some embodiments, the mass of the mass element 130 may be less than 8 g. In some embodiments, the mass of the mass element 130 may be less than 10 g.

FIG. 8 is a schematic diagram illustrating frequency response curves of acoustic output devices according to some embodiments of the present disclosure.

In FIG. 8, curve L81 is a frequency response curve when the mass of the second mass element 150 of the acoustic output device 700 is much smaller than the mass of the mass element 130 (which may be approximated as a ratio (denoted by np in FIG. 8) of the mass of the second mass element 150 to the mass of the mass element 130 is 0). Curve L82 is a frequency response curve when a ratio of the mass of the second mass element 150 to the mass of the mass element 130 of the acoustic output device 700 is 2. Curve L83 is a frequency response curve when a ratio of the mass of the second mass element 150 of the acoustic output device 700 to the mass element 130 is 100.

As may be seen from FIG. 8, as the ratio of the mass of the second mass element 150 to the mass of the mass element 130 increases, the resonant frequencies respectively corresponding to a first resonance peak 811 in curve L81, a first resonance peak 821 in curve L82, and a first resonance peak 831 in curve L83 gradually decrease. As an exemplary illustration, as shown in FIG. 8, a resonance frequency corresponding to the first resonance peak 811 is about 350 Hz, a resonance frequency corresponding to the first resonance peak 821 is about 250 Hz, and a resonance frequency corresponding to the first resonance peak 831 is about 75 Hz. Therefore, in some embodiments, in order to ensure that the acoustic output device 700 produces the first resonance peak in a lower frequency band, the mass of the second mass element 150 may be greater than the mass of the mass element 130. Further, by adjusting the ratio of the mass of the second mass element 150 to the mass of the mass element 130, the resonance frequency corresponding to the resonance peak of the acoustic output device 700 can be changed. Specifically, the larger the ratio of the mass of the second mass element 150 to the mass of the mass element 130, the smaller the resonance frequency corresponding to the resonance peak of the acoustic output device 700. In some embodiments, the ratio of the mass of the second mass element 150 to the mass of the mass element 130 may be within a range of 0-5. In some embodiments, the ratio of the mass of the second mass element 150 to the mass of the mass element 130 may be within a range of 0-10. In some embodiments, the ratio of the mass of the second mass element 150 to the mass of the mass element 130 may be within a range of 0-20. In some embodiments, the ratio of the mass of the second mass element 150 to the mass of the mass element 130 may be within a range of 0-50. In some embodiments, the ratio of the mass of the second mass element 150 to the mass of the mass element 130 may be within a range of 0-100.

In some embodiments, in the acoustic output device 700, when the mass of the second mass element 150 is much larger than the mass of the mass element 130 (e.g., the ratio of the mass of the second mass element 150 to the mass of the mass element 130 is greater than or equal to 100), the vibration element 110 (the beam structure) may tend to be fixed at one end connected to the second mass element 150, and the end of the beam structure connected to the second mass element 150 may be regarded as the fixing end. In such cases, the acoustic output device 700 may be equivalent to the acoustic output device 200. By setting in this way, the second mass element 150 may be used as a fixing boundary (the fixing end) of the beam structure, so as to solve the problem that it is difficult to find the fixing boundary for fixing the fixing end of the beam structure in the acoustic output device (e.g., in the housing structure).

In some embodiments, in the acoustic output device 700, when the mass of the second mass element 150 is much larger than the mass of the mass element 130, the acoustic output device 700 may be equivalent to the acoustic output device 200. Therefore, according to the descriptions related to the acoustic output device 200, in order to ensure that the acoustic output device 700 may produce the first resonance peak in the low frequency band, a ratio of a distance between the second mass element 150 and the piezoelectric element 120 to the length of the beam structure may be less than 0.8. In some embodiments, a ratio of the distance between the second mass element 150 and the piezoelectric element 120 to the length of the beam structure may be less than 0.6. In some embodiments, a ratio of the distance between the second mass element 150 and the piezoelectric element 120 to the length of the beam structure may be less than 0.4.

FIG. 9 is a schematic diagram illustrating a structure of an acoustic output device according to some embodiments of the present disclosure.

As shown in FIG. 9, a structure of an acoustic output device 900 may be seen as the structure of the acoustic output device 200 having some variations. Specifically, a difference between the acoustic output device 900 and the acoustic output device 200 is that the acoustic output device 900 may also include a second piezoelectric element 140 attached to a third position of the beam structure. The piezoelectric element 120 and the second piezoelectric element 140 may be spaced apart along the length direction of the vibration element 110 (or referred to as the beam structure).

In some embodiments, the second piezoelectric element 140 and the piezoelectric element 120 may have the same or similar structure, material, etc. In some embodiments, the piezoelectric element 120 and the second piezoelectric element 140 are spaced apart along the length direction of the vibration element 110 (or referred to as the beam structure), and signals input by the piezoelectric element 120 and the second piezoelectric element 140 may be the same, such that the piezoelectric element 120 and the second piezoelectric element 140 may be viewed as being connected in series. In some embodiments, the second piezoelectric element 140 and the piezoelectric element 120 may be in the d31 operation mode, and deformation directions of the piezoelectric element 120 and the second piezoelectric element 140 may be perpendicular to the vibration direction of the vibration element 110.

In some embodiments, in the vibration direction of the vibration element 110, the piezoelectric element 120 and the second piezoelectric element 140 may be located on the same side of the beam structure. For example, as shown in FIG. 9, the piezoelectric element 120 and the second piezoelectric element 140 may be respectively attached to the first position and the third position of the beam structure and located on the same side of the beam structure. In some embodiments, the piezoelectric element 120 and the second piezoelectric element 140 may be located on opposite sides of the beam structure along the vibration direction of the vibration element 110. For example, the piezoelectric element 120 and the second piezoelectric element 140 may be respectively attached to the first position and the third position of the beam structure and located on opposite sides of the beam structure.

It is noted that a count of piezoelectric elements shown in FIG. 9 is merely provided for the purposes of illustration, and not intended to limit the scope of the present disclosure. In some embodiments, the acoustic output device 900 may also include two or more piezoelectric elements, e.g., three piezoelectric elements, four piezoelectric elements, five piezoelectric elements, etc. The two or more piezoelectric elements may be spaced apart along the length direction of the beam structure. In some embodiments, a distance of two adjacent piezoelectric elements of the two or more piezoelectric elements along the length direction of the beam structure may be the same or different. In some embodiments, as shown in FIG. 9, the piezoelectric element 120 and the second piezoelectric element 140 may be located on the same side of the mass element 130. In some embodiments, the piezoelectric element 120 and the second piezoelectric element 140 may also be located on both sides of the mass element 130. For example, the piezoelectric element 120, the mass element 130, and the second piezoelectric element 140 are arranged sequentially along the length direction of the beam structure.

The acoustic output device 900 may be described in detail below with reference to drawings of the frequency curve of the acoustic output device 900.

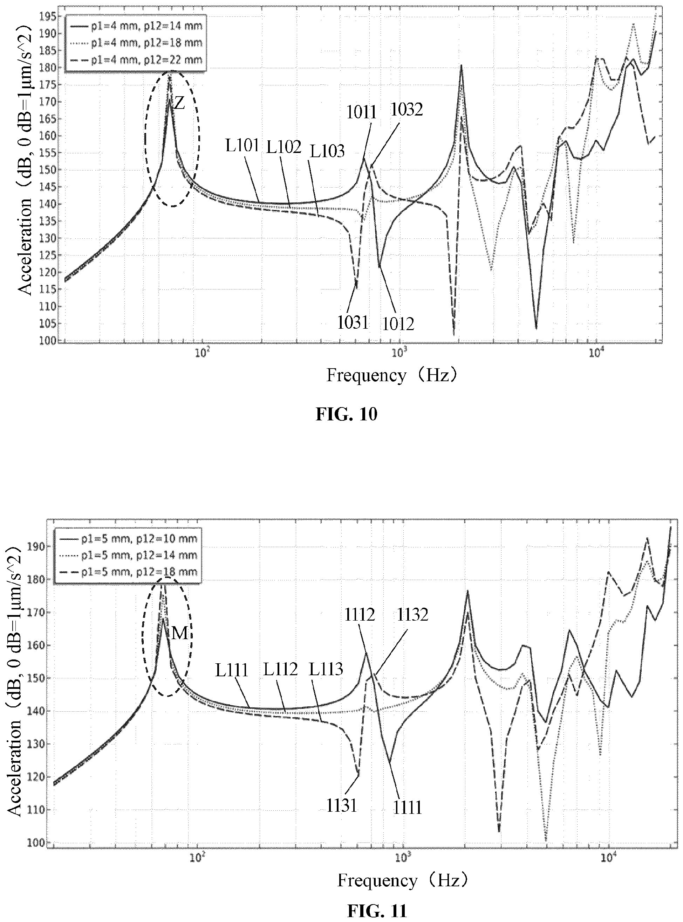

FIG. 10 is a schematic diagram illustrating frequency response curves of acoustic output devices according to some embodiments of the present disclosure.

FIG. 10 illustrates different frequency response curves of the acoustic output device 900 when the distance between the piezoelectric element 120 and the second piezoelectric element 140 along the length direction of the beam structure have different values (denoted by p12 in the figure) under a condition that a length of the beam structure of the acoustic output device 900 is 50 mm, lengths of both the piezoelectric element 120 and the second piezoelectric element 140 (i.e., the size of the attachment area between the piezoelectric element 120 and the beam structure along the length direction of the beam structure) are 5 mm, and a distance between the fixing end and the piezoelectric element 120 or the second piezoelectric element 140 is 4 mm (denoted by p1 in the figure). The distance between the piezoelectric element 120 and the second piezoelectric element 140 along the length direction of the beam structure may refer to the distance between the center point (e.g., the centroid) of the piezoelectric element 120 and the center point of the second piezoelectric element 140. Curve L 101, curve L 102, and curve L 103 are the frequency response curves of the acoustic output device 900 when the distances between the piezoelectric element 120 and the second piezoelectric element 140 along the length direction of the beam structure are 14 mm, 18 mm, and 22 mm, respectively. The dotted circle Z indicates the first resonance peak generated by the vibration element 110 and the mass element 130 in the low frequency band (e.g., 50 Hz - 2000 Hz). In some embodiments, the distance between the piezoelectric element 120 and the second piezoelectric element 140 along the length direction of the beam structure may refer to a length of a spacing area between the piezoelectric element 120 and the second piezoelectric element 140 along the length direction of the beam structure.

As can be seen from FIG. 10, when a length of the beam structure of the acoustic output device 900 is 50 mm, lengths of both the piezoelectric element 120 and the second piezoelectric element 140 are both 5 mm, a distance between the fixing end and the piezoelectric element 120 or the second piezoelectric element 140 is 4 mm and a distance between the piezoelectric element 120 and the second piezoelectric element 140 along the length direction of the beam structure is 18 mm, the frequency response curve (i.e., curve L102) of the acoustic output device 900 in the mid-to-high frequency band (e.g., 200 Hz to 2000 Hz) is relatively smooth, which is specifically shown that the curve L102 has small or no resonance peaks and/or resonance valleys in the mid-to-high frequency band. When the distance between the piezoelectric element 120 and the second piezoelectric element 140 along the length direction of the beam structure is 14 mm or 22 mm, the frequency response curve (i.e., curve L101 or curve L103) of the acoustic output device 900 has the resonance peaks and/or resonance valleys in the mid-to-high frequency band. As an exemplary illustration, as shown in FIG. 10, curve L101 has a resonance peak 1011 and a resonance valley 1012 within the range of 200 Hz to 2000 Hz, and curve L103 has a resonance valley 1031 and a resonance peak 1032 within the range of 200 Hz to 2000 Hz. Therefore, the resonance valleys and resonance peaks (e.g., the resonance peak 1011 and the resonance valley 1012, the resonance valley 1031 and the resonance peak 1032) generated by the acoustic output device 900 in the mid-to-high frequency band may be combined (or referred to as be canceled) by rationally designing the distance (e.g., 18 mm) between the piezoelectric element 120 and the second piezoelectric element 140 along the length direction of the beam structure, so that the frequency response curve (e.g., curve L102) of the acoustic output device 900 is relatively flatter, thereby ensuring that the acoustic output device 900 has the relatively better sound quality.

FIG. 11 is a schematic diagram illustrating frequency response curves of acoustic output devices according to some embodiments of the present disclosure.

FIG. 11 illustrates different frequency response curves of the acoustic output device 900 when the distance between the piezoelectric element 120 and the second piezoelectric element 140 along the length direction of the beam structure have different values under a condition that a length of the beam structure of the acoustic output device 900 is 50 mm, the lengths of both the piezoelectric element 120 and the second piezoelectric element 140 are 5 mm, and a distance between the fixing end and the piezoelectric element 120 or the second piezoelectric element 140 is 5 mm. Curve L111, curve L112 and curve L113 are respectively the frequency response curves of the acoustic output device 900 when the distances between the piezoelectric element 120 and the second piezoelectric element 140 along the length direction of the beam structure are 12 mm, 14 mm and 18 mm. The dotted circle M indicates the first resonance peak generated by the vibration element 110 and the mass element 130 in the low frequency band (e.g., 50 Hz to 2000 Hz).

As can be seen from FIG. 11, when the length of the beam structure of the acoustic output device 900 is 50 mm, the lengths of the piezoelectric element 120 and the second piezoelectric element 140 are 5 mm, the distance between the fixing end and the piezoelectric element 120 or the second piezoelectric element 140 is 5 mm, and the distance between the piezoelectric element 120 and the second piezoelectric element 140 along the length direction of the beam structure is 14 mm, the frequency response curve (i.e., curve L 112) of the acoustic output device 900 in the mid-to-high frequency band (e.g., 200 Hz to 2000 Hz) is relatively smooth, which is specifically shown that the curve L112 has small or no resonance peaks and/or resonance valleys in the mid-to-high frequency band. When the distance between the piezoelectric element 120 and the second piezoelectric element 140 along the length direction of the beam structure is 10 mm or 18 mm, the frequency response curve (i.e., curve L111 or curve L 113) of the acoustic output device 900 has the resonance peaks and/or the resonance valleys in the mid-to-high frequency band. As an exemplary illustration, as shown in FIG. 11, curve L111 has a resonance peak 1111 and a resonance valley 1112 within the range of 200 Hz to 2000 Hz, and curve L 113 has a resonance valley 1131 and a resonance peak 1132 within the range of 200 Hz to 2000 Hz. Therefore, the resonance valleys and resonance peaks (e.g., the resonance peak 1111 and the resonance valley 1112, the resonance valley 1131 and the resonance peak 1132) generated by the acoustic output device 900 in the mid-to-high frequency band may be combined (or referred to as be canceled) by rationally designing the distance (e.g., 14 mm) between the piezoelectric element 120 and the second piezoelectric element 140 along the length direction of the beam structure, so that the frequency response curve (e.g., curve L112) of the acoustic output device 900 is relatively flatter, thereby ensuring that the acoustic output device 900 has the relatively better sound quality.

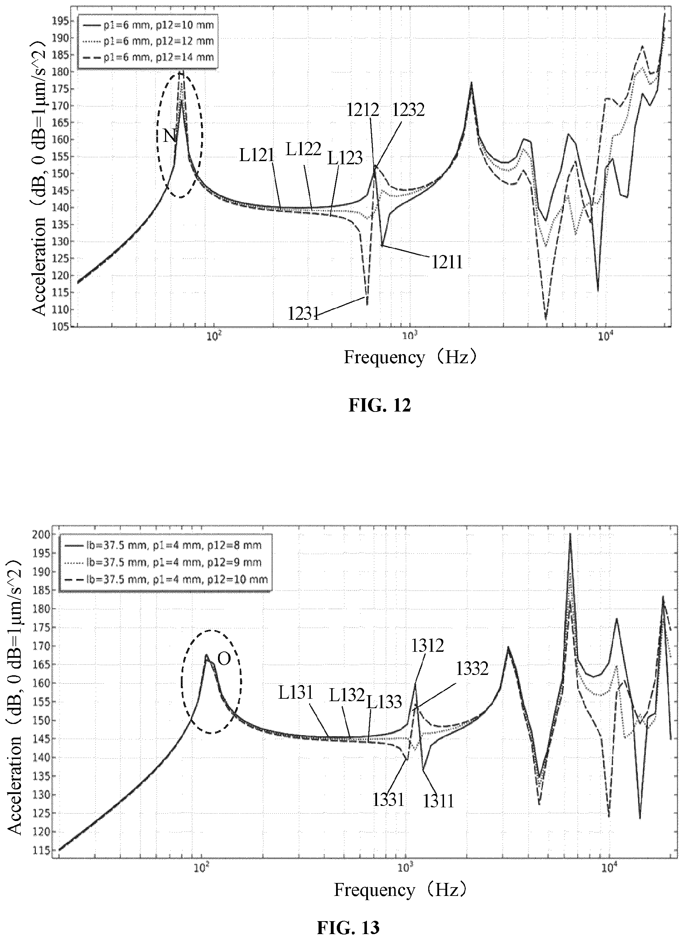

FIG. 12 is a schematic diagram illustrating frequency response curves of acoustic output devices according to some embodiments of the present disclosure.

FIG. 12 illustrates different frequency response curves of the acoustic output device 900 when the distance between the piezoelectric element 120 and the second piezoelectric element 140 along the length direction of the beam structure have different values under a condition that the length of the beam structure of the acoustic output device 900 is 50 mm, the lengths of both the piezoelectric element 120 and the second piezoelectric element 140 are 5 mm, and the distance between the fixing end and the piezoelectric element 120 or the second piezoelectric element 140 is 6 mm. Curve L121, curve L122, and curve L123 are the frequency response curves of the acoustic output device 900 when the distances between the piezoelectric element 120 and the second piezoelectric element 140 along the length direction of the beam structure are 10 mm, 12mm, 14 mm, respectively. The dotted circle N indicates the first resonance peak generated by the vibration element 110 and the mass element 130 in the low frequency band (e.g., 50 Hz to 2000 Hz).

As can be seen from FIG. 12, when the length of the beam structure of the acoustic output device 900 is 50 mm, the lengths of the piezoelectric element 120 and the second piezoelectric element 140 are 5 mm, the distance between the fixing end and the piezoelectric element 120 or the second piezoelectric element 140 is 6 mm, and the distance between the piezoelectric element 120 and the second piezoelectric element 140 along the length direction of the beam structure is 12 mm, the frequency response curve (i.e., curve L122) of the acoustic output device 900 in the mid-to-high frequency band (e.g., 200 Hz to 2000 Hz) is relatively smooth, which is specifically shown that the curve L122 having the small or no resonance peaks and/or resonance valleys in the mid-to-high frequency band. When the distance between the piezoelectric element 120 and the second piezoelectric element 140 along the length direction of the beam structure is 10 mm or 14 mm, the frequency response curve (i.e., curve L121 or curve L123) of the acoustic output device 900 has the resonance peaks and/or resonance valleys in the mid-to-high frequency band. As an exemplary illustration, as shown in FIG. 12, curve L121 has a resonance peak 1211 and a resonance valley 1212 within the range of 200 Hz to 2000 Hz, and curve L123 has a resonance valley 1231 and a resonance peak 1232 within the range of 200 Hz to 2000 Hz. Therefore, the resonance valleys and resonance peaks (e.g., the resonance peak 1211 and the resonance valley 1212, the resonance valley 1231 and the resonance peak 1232) generated by the acoustic output device 900 in the mid-to-high frequency band may be combined (or referred to as be canceled) by rationally designing the distance between the piezoelectric element 120 and the second piezoelectric element 140 along the length direction of the beam structure (e.g., 12 mm), so that the frequency response curve (e.g., curve L122) of the acoustic output device 900 is relatively flatter, thereby ensuring that the acoustic output device 900 has the relatively better sound quality.

According to FIG. 10, FIG. 11, and FIG. 12, when the lengths of the beam structure and the lengths of the piezoelectric element 120 and the second piezoelectric element 140 are constant, as the distance between the piezoelectric element 120 or the second piezoelectric element 140 and the fixing end 111 increases (e.g., in FIG. 10 to FIG. 12 it is 4 mm, 5 mm, and 6 mm in sequence), the distance between the piezoelectric element 120 and the second piezoelectric element 140 corresponding to the combined resonance peak and resonance valley along the length direction of the beam structure gradually decreases (e.g., in FIG. 10 to FIG. 12, it is 18 mm, 14 mm, and 12 mm in sequence). Therefore, in some embodiments, the distance between the piezoelectric element 120 and the second piezoelectric element 140 along the length direction of the beam structure may be adjusted based on different distances between the piezoelectric element 120 or the second piezoelectric element 140 and the fixing end 111. Merely by way of example, when the distance between the piezoelectric element 120 or the second piezoelectric element 140 and the fixing end 111 increases, the distance between the piezoelectric element 120 and the second piezoelectric element 140 along the length direction of the beam structure may be appropriately reduced, so that the resonance peaks and resonance valleys can be combined, thereby causing the frequency response curve of the acoustic output device 900 to be flatter and improving the sound quality of the acoustic output device 900. For example, a ratio of the distance between the piezoelectric element 120 or the second piezoelectric element 140 and the fixing end 111 to the length of the beam structure is greater than 0.05, and a ratio of the distance between the piezoelectric element 120 and the second piezoelectric element 140 along the length direction of the beam structure to the length of the beam structure may be less than 0.5. As another example, a ratio of the distance between the piezoelectric element 120 or the second piezoelectric element 140 and the fixing end 111 to the length of the beam structure is greater than 0.08, and a ratio of the distance between the piezoelectric element 120 and the second piezoelectric element 140 along the length direction of the beam structure to the length of the beam structure may be less than 0.4. As another example, a ratio of the distance between the piezoelectric element 120 or the second piezoelectric element 140 and the fixing end 111 to the length of the beam structure is greater than 0.1, and a ratio of the distance between the piezoelectric element 120 and the second piezoelectric element 140 along the length direction of the beam structure to the length of the beam structure may be less than 0.3. As another example, a ratio of the distance between the piezoelectric element 120 or the second piezoelectric element 140 and the fixing end 111 to the length of the beam structure is greater than 0.12, a ratio of the distance between the piezoelectric element 120 and the second piezoelectric element 140 along the length direction of the beam structure to the length of the beam structure may be less than 0.25.

FIG. 13 is a schematic diagram illustrating frequency response curves of acoustic output devices according to some embodiments of the present disclosure.

FIG. 13 illustrates different frequency response curves of the acoustic output device 900 when the distance between the piezoelectric element 120 and the second piezoelectric element 140 along the length direction of the beam structure have different values under a condition that the length (denoted by lb in the figure) of the beam structure of the acoustic output device 900 is 37.5 mm, the lengths of both the piezoelectric element 120 and the second piezoelectric element 140 are 5 mm, and a distance between the fixing end and the piezoelectric element 120 or the second piezoelectric element 140 is 4 mm. Curve L131, curve L132, and curve L123 are respectively the frequency response curves of the acoustic output device 900 when the distances between the piezoelectric element 120 and the second piezoelectric element 140 along the length direction of the beam structure are 8 mm. The dotted circle O indicates the first resonance peak generated by the vibration element 110 and the mass element 130 in the low frequency band (e.g., 50 Hz to 2000 Hz).

As can be seen from FIG. 13, when the length of the beam structure of the acoustic output device 900 is 37.5 mm, the lengths of the piezoelectric element 120 and the second piezoelectric element 140 are 5 mm, the distance between the fixing end and the piezoelectric element 120 or the second piezoelectric element 140 is 4 mm, and the distance between the piezoelectric element 120 and the second piezoelectric element 140 along the length direction of the beam structure is 9 mm, the frequency response curve (i.e., curve L132) of the acoustic output device 900 in the mid-to-high frequency band (e.g., 200 Hz to 2000 Hz) is relatively smooth, which is specifically shown that the curve L132 has the small or no resonance peaks and/or resonance valleys in the mid-to-high frequency band. When the distance between the piezoelectric element 120 and the second piezoelectric element 140 along the length direction of the beam structure is 8 mm or 10 mm, the frequency response curve (i.e., curve L131 or curve L133) of the acoustic output device 900 has the resonance peaks and/or the resonance valleys in the mid-to-high frequency band. As an exemplary illustration, as shown in FIG. 13, curve L131 has a resonance peak 1311 and a resonance valley 1312 within the range of 200 Hz to 2000 Hz, and curve L133 has a resonance valley 1331 and a resonance peak 1132 within the range of 200 Hz to 2000 Hz. Therefore, the resonance valleys and resonance peaks (e.g., the resonance peak 1311 and the resonance valley 1312, the resonance valley 1331 and the resonance peak 1332) generated by the acoustic output device 900 in the mid-to-high frequency band may be combined (or referred to as be canceled) by rationally designing the distance between the piezoelectric element 120 and the second piezoelectric element 140 along the length direction of the beam structure (e.g., 9 mm), so that the frequency response curve of the acoustic output device 900 is relatively flatter, thereby ensuring that the acoustic output device 900 has the relatively better sound quality.

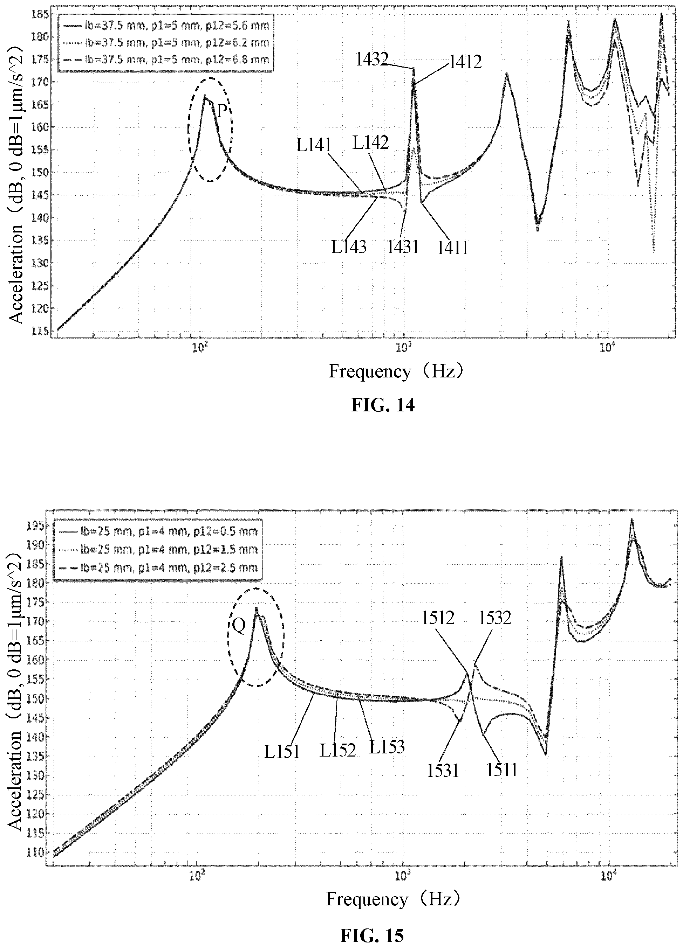

FIG. 14 is a schematic diagram illustrating frequency response curves of acoustic output devices according to some embodiments of the present disclosure.

FIG. 14 illustrates different frequency response curves of the acoustic output device 900 when the distance between the piezoelectric element 120 and the second piezoelectric element 140 along the length direction of the beam structure have different values under a condition that the length of the beam structure of the acoustic output device 900 is 37.5 mm, the lengths of both the piezoelectric element 120 and the second piezoelectric element 140 are 5 mm, and a distance between the fixing end and the piezoelectric element 120 or the second piezoelectric element 140 is 5 mm. Curve L141, curve L142, and curve L143 are respectively the frequency response curves of the acoustic output device 900 when the distances between the piezoelectric element 120 and the second piezoelectric element 140 along the length direction of the beam structure are 5.6 mm, 6.2 mm and 6.8 mm. The dotted circle P indicates the first resonance peak generated by the vibration element 110 and the mass element 130 in the low frequency band (e.g., 50 Hz to 2000 Hz).

As can be seen from FIG. 14, when the length of the beam structure of the acoustic output device 900 is 37.5 mm, the lengths of the piezoelectric element 120 and the second piezoelectric element 140 are 5 mm, the distance between the fixing end and the piezoelectric element 120 or the second piezoelectric element 140 is 5 mm, and the distance between the piezoelectric element 120 and the second piezoelectric element 140 along the length direction of the beam structure is 6.2 mm, the frequency response curve (i.e., curve L142) of the acoustic output device 900 in the mid-to-high frequency band (e.g., 200 Hz to 2000 Hz) is relatively smooth, which is specifically shown that the curve L142 has the small or no resonance peaks and/or resonance valleys in the mid-to-high frequency band. When a distance between the piezoelectric element 120 and the second piezoelectric element 140 along the length direction of the beam structure is 5.6 mm or 6.8 mm, the frequency response curve (i.e., curve L141 or curve L143) of the acoustic output device 900 has the resonance peaks and/or resonance valleys in the mid-to-high frequency band. As an exemplary illustration, curve L141 has a resonance peak 1411 and a resonance valley 1412 within the range of 200 Hz to 2000 Hz, and curve L 143 has a resonance valley 1431 and a resonance peak 1432 within the range of 200 Hz to 2000 Hz, as shown in FIG. 13. Therefore, the resonance valleys and resonance peaks (e.g., the resonance peak 1411 and the resonance valley 1412, the resonance valley 1431 and the resonance peak 1432) generated by the acoustic output device 900 in the mid-to-high frequency band may be combined (or referred to as be canceled) by rationally designing the distance between the piezoelectric element 120 and the second piezoelectric element 140 along the length direction of the beam structure (e.g., 6.2 mm), so that the frequency response curve of the acoustic output device 900 is relatively flatter, thereby ensuring that the acoustic output device 900 has the relatively better sound quality.

According to FIG. 13 and FIG. 14, when the length of the beam structure and the lengths of the piezoelectric element 120 and the second piezoelectric element 140 are constant, as the distance between the piezoelectric element 120 or the second piezoelectric element 140 and the fixing end 111 increases (e.g. in FIG. 13 and FIG. 14, it is 4 mm and 5 mm, respectively), the distance between the piezoelectric element 120 and the second piezoelectric element 140 corresponding to the combined resonance peak and resonance valley along the length direction of the beam structure gradually decreases (e.g., in FIG. 13 and FIG. 14, it is 9 mm and 6.2 mm, respectively). Therefore, in some embodiments, the distance between the piezoelectric element 120 and the second piezoelectric element 140 along the length direction of the beam structure may be adjusted based on different distances between the piezoelectric element 120 or the second piezoelectric element 140 and the fixing end 111. Merely by way of example, when the distance between the piezoelectric element 120 or the second piezoelectric element 140 and the fixing end 111 increases, the distance between the piezoelectric element 120 and the second piezoelectric element 140 along the length direction of the beam structure may be appropriately reduced, so that the resonance peaks and resonance valleys can be combined, thereby causing the frequency response curve of the acoustic output device 900 to be flatter and improving the sound quality of the acoustic output device 900. For example, a ratio of the distance between the piezoelectric element 120 or the second piezoelectric element 140 and the fixing end 111 to the length of the beam structure is greater than 0.1, and a ratio of the distance between the piezoelectric element 120 and the second piezoelectric element 140 along the length direction of the beam structure to the length of the beam structure may be less than 0.25. As another example, a ratio of the distance between the piezoelectric element 120 or the second piezoelectric element 140 and the fixing end 111 to the length of the beam structure is greater than 0.13, and a ratio of the distance between the piezoelectric element 120 and the second piezoelectric element 140 along the length direction of the beam structure to the length of the beam structure may be less than 0.2.

FIG. 15 is a schematic diagram illustrating frequency response curves of acoustic output devices according to some embodiments of the present disclosure.

FIG. 15 illustrates different frequency response curves of the acoustic output device 900 when the distance between the piezoelectric element 120 and the second piezoelectric element 140 along the length direction of the beam structure have different values under a condition that a length of the beam structure of the acoustic output device 900 is 25 mm, the lengths of both the piezoelectric element 120 and the second piezoelectric element 140 are 5 mm, and a distance between the fixing end and the piezoelectric element 120 or the second piezoelectric element 140 is 4 mm. Curve L151, curve L152, and curve L153 are respectively the frequency response curves of the acoustic output device 900 when the distances between the piezoelectric element 120 and the second piezoelectric element 140 along the length direction of the beam structure are 5.6 mm, 6.2 mm, and 6.8 mm. The dotted circle Q indicates the first resonance peak generated by the vibration element 110 and the mass element 130 in the low frequency band (e.g., 50 Hz to 2000 Hz).

As can be seen from FIG. 15, when the length of the beam structure of the acoustic output device 900 is 25 mm, the lengths of the piezoelectric element 120 and the second piezoelectric element 140 are 5 mm, the distance between the fixing end and the piezoelectric element 120 or the second piezoelectric element 140 is 4 mm, and the distance between the piezoelectric element 120 and the second piezoelectric element 140 along the length direction of the beam structure is 1.5 mm, the frequency response curve (i.e., curve L152) of the acoustic output device 900 in the mid-to-high frequency band (e.g., 300 Hz to 3000 Hz) is relatively smooth, which is specifically shown that the curve L152 has the small or no resonance peaks and/or resonance valleys in the mid-to-high frequency band. When a distance between the piezoelectric element 120 and the second piezoelectric element 140 along the length direction of the beam structure is 0.5 mm or 2.5 mm, the frequency response curve (i.e., curve L151 or curve L153) of the acoustic output device 900 has the resonance peaks and/or resonance valleys in the mid-to-high frequency band. As an exemplary illustration, curve L151 has a resonance peak 1511 and a resonance valley 1512 within the range of 300 Hz to 3000 Hz, and curve L153 has a resonance valley 1531 and a resonance peak 1532 within the range of 300 Hz to 3000 Hz, as shown in FIG. 15. Therefore, the resonance valleys and resonance peaks (e.g., the resonance peak 1511 and the resonance valley 1512, the resonance valley 1531 and the resonance peak 1532) generated by the acoustic output device 900 in the mid-to-high frequency band may be combined (or referred to as be canceled) by rationally designing the distance between the piezoelectric element 120 and the second piezoelectric element 140 along the length direction of the beam structure (e.g., 1.5 mm), so that the frequency response curve of the acoustic output device 900 is relatively flatter, thereby ensuring that the acoustic output device 900 has the relatively better sound quality.

According to FIG. 10, FIG. 13, and FIG. 15, when the length of the beam structure and the lengths of the piezoelectric element 120 and the second piezoelectric element 140 are constant, as the distance between the piezoelectric element 120 or the second piezoelectric element 140 and the fixing end 111 increases (e.g., in FIG. 10, FIG. 13, and FIG. 15, it is 50 mm, 37.5 mm, and 25 mm in sequence), the distance between the piezoelectric element 120 and the second piezoelectric element 140 corresponding to the combined resonance peak and resonance valley along the length direction of the beam structure gradually decreases (e.g., in FIG. 10, FIG. 13, and FIG. 15, it is 18 mm, 9 mm, and 1.5 mm in sequence). Therefore, in some embodiments, the distance between the piezoelectric element 120 and the second piezoelectric element 140 along the length direction of the beam structure may be adjusted based on different distances between the piezoelectric element 120 and the second piezoelectric element 140. Merely by way of example, when the distance of the beam structure decreases, the distance between the piezoelectric element 120 and the second piezoelectric element 140 along the length direction of the beam structure may be appropriately reduced, so that the resonance peaks and resonance valleys can be combined, thereby causing the frequency response curve of the acoustic output device 900 to be flatter and improving the sound quality of the acoustic output device 900. For example, a ratio of the distance between the piezoelectric element 120 and the second piezoelectric element 140 along the length direction of the beam structure to the length of the beam structure may be less than 0.6. As another example, a ratio of the distance between the piezoelectric element 120 and the second piezoelectric element 140 along the length direction of the beam structure to the length of the beam structure may be less than 0.4. As another example, a ratio of the distance between the piezoelectric element 120 and the second piezoelectric element 140 along the length direction of the beam structure to the length of the beam structure may be less than 0.2.

FIG. 16 is a schematic diagram illustrating frequency response curves of acoustic output devices according to some embodiments of the present disclosure.

FIG. 16 illustrates different frequency response curves of the acoustic output device 900 when the distance between the piezoelectric element 120 and the second piezoelectric element 140 along the length direction of the beam structure have different values under a condition that a length of the beam structure of the acoustic output device 900 is 50 mm, the lengths (denoted by lp in the figure) of both the piezoelectric element 120 and the second piezoelectric element 140 are 25 mm, the distance between the fixing end and the piezoelectric element 120 or the second piezoelectric element 140 is 4 mm. Curve L161, curve L162, and curve L163 are respectively the frequency response curves of the acoustic output device 900 when the distances between the piezoelectric element 120 and the second piezoelectric element 140 along the length direction of the beam structure are -4 mm, -2.5 mm, and -1 mm. The dotted circle Q indicates the first resonance peak generated by the vibration element 110 and the mass element 130 in the low frequency band (e.g., 50 Hz to 2000 Hz). The distance between the piezoelectric element 120 and the second piezoelectric element 140 along the length direction of the beam structure may refer to a distance between a center point (e.g., the centroid) of the piezoelectric element 120 and a center point of the second piezoelectric element 140. It should be noted that a distance between the piezoelectric element 120 and the second piezoelectric element 140 along the length direction of the beam structure is 0 may be understood as a projection of the center point of the piezoelectric element 120 along the vibration direction of the beam structure coincides with a projection of the center point of the second piezoelectric element 140 along the vibration direction of the beam structure. The distance between the piezoelectric element 120 and the second piezoelectric element 140 along the length direction of the beam structure is positive may be understood as the distance between the center point of the piezoelectric element 120 and the center point of the second piezoelectric element 140 when a position of one of the piezoelectric elements (e.g., the second piezoelectric element 140) is constant and the other piezoelectric element (e.g., the piezoelectric element 120) moves to the mass element 130 along the length direction of the beam structure. The distance between the piezoelectric element 120 and the second piezoelectric element 140 along the length direction of the beam structure is negative may be understood as the distance between the center point of the piezoelectric element 120 and the center point of the second piezoelectric element 140 when the position of one of the piezoelectric elements (e.g., the second piezoelectric element 140) is constant and the other piezoelectric element (e.g., the piezoelectric element 120) moves to the fixing end 111 along the length direction of the beam structure.

As can be seen from FIG. 16, when the length of the beam structure of the acoustic output device 900 is 50 mm, the lengths of the piezoelectric element 120 and the second piezoelectric element 140 are both 25 mm, the distance between the fixing end and the piezoelectric element 120 or the second piezoelectric element 140 is 4 mm, and the distance between the piezoelectric element 120 and the second piezoelectric element 140 along the length direction of the beam structure is -2.5 mm, the frequency response curve (i.e., curve L162) of the acoustic output device 900 in the mid-to-high frequency band (e.g., 300 Hz to 3000 Hz) is relatively smooth, which is specifically shown that the curve L162 has the small or no resonance peaks and/or resonance valleys in the mid-to-high frequency band. When a distance between the piezoelectric element 120 and the second piezoelectric element 140 along the length direction of the beam structure is -4 mm or -1 mm, the frequency response curve (i.e., curve L161 or curve L163) of the acoustic output device 900 has the resonance peaks and/or resonance valleys in the mid-to-high frequency band. As an exemplary illustration, curve L161 has a resonance peak 1611 and a resonance valley 1612 within the range of 300 Hz to 3000 Hz, and curve L163 has a resonance valley 1631 and a resonance peak 1632 within the range of 300 Hz to 3000 Hz, as shown in FIG. 16. Therefore, the resonance valleys and resonance peaks (e.g., the resonance peak 1611 and the resonance valley 1612, the resonance valley 1631 and the resonance peak 1632) generated by the acoustic output device 900 in the mid-to-high frequency band may be combined (or referred to as be canceled) by rationally designing the distance between the piezoelectric element 120 and the second piezoelectric element 140 along the length direction of the beam structure (e.g., -2.5 mm), so that the frequency response curve of the acoustic output device 900 is relatively flatter, thereby ensuring that the acoustic output device 900 has the relatively better sound quality.

According to FIG. 10 and FIG. 16, when the length of the beam structure and the distance between the piezoelectric element 120 or the second piezoelectric element 140 and the fixing end 111 are constant, as the lengths of the piezoelectric element 120 and the second piezoelectric element 140 increases (e.g., in FIG. 10 and FIG. 16, it is 5 mm and 25 mm, respectively), the distance between the piezoelectric element 120 and the second piezoelectric element 140 corresponding to the combined resonance peak and resonance valley along the length direction of the beam structure gradually decreases (e.g., in FIG. 10 and FIG. 16, it is 18 mm, -2.5 mm, respectively). Therefore, in some embodiments, the distance between the piezoelectric element 120 and the second piezoelectric element 140 along the length direction of the beam structure may be adjusted based on different distances between the piezoelectric element 120 and the second piezoelectric element 140. Merely by way of example, when the lengths of the piezoelectric element 120 and the second piezoelectric element 140 increase, the distance between the piezoelectric element 120 and the second piezoelectric element 140 along the length direction of the beam structure may be appropriately reduced, so that the resonance peaks and resonance valleys can be combined, thereby causing the frequency response curve of the acoustic output device 900 to be flatter and improving the sound quality of the acoustic output device 900. For example, a ratio of the length of the piezoelectric element 120 or the second piezoelectric element 140 to the length of the beam structure is greater than 0.05, and a ratio of the distance between the piezoelectric element 120 and the second piezoelectric element 140 to the length of the beam structure is less than 0.4. As another example, a ratio of the length of the piezoelectric element 120 or the second piezoelectric element 140 to the length of the beam structure is greater than 0.1, and a ratio of the distance between the piezoelectric element 120 and the second piezoelectric element 140 to the length of the beam structure is less than 0.2. As another example, a ratio of the length of the piezoelectric element 120 or the second piezoelectric element 140 to the length of the beam structure is greater than 0.2, and a ratio of the distance between the piezoelectric element 120 and the second piezoelectric element 140 to the length of the beam structure is less than 0.1. As another example, a ratio of the length of the piezoelectric element 120 or the second piezoelectric element 140 to the length of the beam structure is greater than 0.4, and a ratio of the distance between the piezoelectric element 120 and the second piezoelectric element 140 to the length of the beam structure is less than 0.

According to FIG. 10 to FIG. 16, the frequency response curves of the acoustic output device 900 (e.g., curves L102, L112, L122, L132, L142, L152, and L162) are relatively smoother in the mid-to-high frequency band by rationally designing the distance between the piezoelectric element 120 and the second piezoelectric element 140, thereby allowing the acoustic output device 900 to have the relatively better sound quality. In some embodiments, the length of the beam structure may be less than 50 mm, and a distance between the piezoelectric element 120 and the second piezoelectric element 140 may be less than 25 mm. In some embodiments, the length of the beam structure may be less than 50 mm, and a distance between the piezoelectric element 120 and the second piezoelectric element 140 may be less than 22 mm. In some embodiments, the length of the beam structure may be less than 50 mm, and a distance between the piezoelectric element 120 and the second piezoelectric element 140 may be less than 18 mm. In some embodiments, the length of the beam structure may be less than 50 mm, and a distance between the piezoelectric element 120 and the second piezoelectric element 140 may be less than 14 mm. In some embodiments, the length of the beam structure may be less than 40 mm, and a distance between the piezoelectric element 120 and the second piezoelectric element 140 may be less than 10 mm. In some embodiments, the length of the beam structure may be less than 40 mm, and a distance between the piezoelectric element 120 and the second piezoelectric element 140 may be less than 7 mm. In some embodiments, the length of the beam structure may be less than 40 mm, and a distance between the piezoelectric element 120 and the second piezoelectric element 140 may be less than 2.5 mm. In some embodiments, the length of the beam structure may be less than 30 mm, and a distance between the piezoelectric element 120 and the second piezoelectric element 140 may be less than -1 mm.

According to curve L101, curve L112, and curve L123, it may be seen that under a condition that the length of the beam structure, the length of the piezoelectric element 120, and the distance between the piezoelectric element 120 and the second piezoelectric element 140 are constant, when the distance between the piezoelectric element 120 or the second piezoelectric element 140 and the fixing end (for example, the distance between the second piezoelectric element 140 and the fixing end shown in FIG. 9) increases, the peak value of the first resonance peak generated by the acoustic output device 900 in the low frequency band increases. As an exemplary illustration, a peak value of the first resonance peak of curve L 101 in the dotted circle Z is about 170 dB, a peak value of the first resonance peak of curve L 112 in the dotted circle M is about 175 dB, and a peak value of the first resonance peak of curve L123 in the dotted circle N is about 180 dB. In some embodiments, the peak value of the first resonance peak of the acoustic output device 900 in the low frequency band may be increased by increasing the distance between the piezoelectric element 120 or the second piezoelectric element 140 and the fixing end, such that the sensitivity of the acoustic output device 900 in the low frequency band may be improved. In some embodiments, a distance between the piezoelectric element 120 or the second piezoelectric element 140 and the fixing end may be greater than 3 mm. In some embodiments, a distance between the piezoelectric element 120 or the second piezoelectric element 140 and the fixing end may be greater than 4 mm. In some embodiments, a distance between the piezoelectric element 120 or the second piezoelectric element 140 and the fixing end may be greater than 5 mm. In some embodiments, a distance between the piezoelectric element 120 or the second piezoelectric element 140 and the fixing end may be greater than 6 mm. In some embodiments, a distance between the piezoelectric element 120 or the second piezoelectric element 140 and the fixing end may be greater than 7 mm.

FIG. 17 is a schematic diagram illustrating a structure of an acoustic output device according to some embodiments of the present disclosure.

As shown in FIG. 17, a structure of an acoustic output device 1700 may be seen as the structure of the acoustic output device 200 having some variations. Specifically, a difference between the acoustic output device 1700 and the acoustic output device 200 is that the acoustic output device 1700 may also include a second piezoelectric element 160, and the vibration element 110 and the second piezoelectric element 160 are arranged symmetrically on both sides of the mass element 130. The acoustic output device 1700 may include a third piezoelectric element 170 connected (or attached) to the second vibration element 160, and the third piezoelectric element 170 and the piezoelectric element 120 are arranged symmetrically on the both sides of the mass element 130. In some embodiments, the piezoelectric element 120 and the third piezoelectric element 170 are respectively arranged on two piezoelectric beams located on the both sides of the mass element 130, and the electrical signals input by the piezoelectric element 120 and the third piezoelectric element 170 may be the same, such that the piezoelectric element 120 may be viewed as being connected in parallel with the third piezoelectric element 170. In some embodiments, the vibration direction of the second vibration element 160 and the vibration direction of the vibration element 110 are the same. In some embodiments, the piezoelectric element 120 and the third piezoelectric element 170 may be in the d31 operation mode, and the deformation direction of the piezoelectric element 120 and the deformation direction of the third piezoelectric element 170 may be perpendicular to the vibration direction of the vibration element 110 and the vibration direction of the second vibration element 160. In some embodiments, the piezoelectric element 120 and the third piezoelectric element 170 may be in the d33 operation mode, and the deformation direction of the piezoelectric element 120 and the deformation direction of the third piezoelectric element 170 may be parallel to the vibration direction of the vibration element 110 and the vibration direction of the second vibration element 160. In some embodiments, one end of the mass element 130 away from the mass element 130 and one end of the second vibration element 160 away from the mass element 130 are fixedly arranged (i.e., the fixing end). For example, one end of the mass element 130 away from the mass element 130 and one end of the second vibration element 160 away from the mass element 130 may be fixed to other elements of the acoustic output device 1700 (e.g., the housing). As another example, the piezoelectric element 120 and the third piezoelectric element 170 may be in the d33 operation mode. The piezoelectric element 120 and the third piezoelectric element 170 are fixed at one end along the vibration directions of the vibration element 110 and the second vibration element 160, and another end of the piezoelectric element 120 and another end of the second piezoelectric element 160 are respectively attached to one end of the vibration element 110 away from the mass element 130 and one end of the second vibration element 160 away from the mass element 130, such that one end of the vibration element 110 away from the mass element 130 and one end of the second vibration element 160 away from the mass element 130 are fixed relative to the mass element 130. More descriptions regarding the second vibration element 160 and the third piezoelectric element 170 may be respectively found in the related descriptions of the vibration element 110 and the piezoelectric element 120, which will not be repeated herein.

FIG. 18 is a schematic diagram illustrating frequency response curves of acoustic output devices according to some embodiments of the present disclosure.

In FIG. 18, curve L181 is a frequency response curve when the vibration element 110 and the second vibration element 160 are connected without a mass element in the middle (or referred to as the vibration element 110 and the second vibration element 160 unloaded). Curve L182 is a frequency response curve when the vibration element 110 and the second vibration element 160 are connected with a mass element in the middle (or referred to as the vibration element 110 and the second vibration element 160 loaded).

As shown in FIG. 18, curves between adjacent resonance peaks on curve L181 and curve L182 are smoother and there are no resonance valleys. Therefore, it may be seen that the frequency response curve of the acoustic output device 1700 may not produce the resonance valleys by setting the structure of the piezoelectric sheets connected in parallel, which makes the frequency response curve smoother and facilitate improving the sound quality of the acoustic output device 1700. In addition, by comparing the resonance peak 1811 of curve L181 with the resonance peak 1821 of curve L182, it may be found that when there is a mass element 130 connected between the vibration element 110 and the second vibration element 160, the resonance frequency corresponding to the resonance peak may decrease. Therefore, the resonance frequency corresponding to the resonance peak generated by the acoustic output device 1700 in the low frequency band (e.g., 100 Hz to 1000 Hz) may be changed by changing the mass of the mass element 130.

FIG. 19 is a schematic diagram illustrating a structure of an acoustic output device according to some embodiments of the present disclosure.

As shown in FIG. 19, a structure of an acoustic output device 1900 may be seen as the structure of the acoustic output device 200 having some variations. Specifically, a difference between the acoustic output device 1900 and the acoustic output device 200 is that the acoustic output device 1900 may also include a third piezoelectric element 180 connected to the mass element 130. The vibration direction of the third vibration element 180 and the vibration direction of the element 110 are parallel. Further, the acoustic output device 1900 may also include a fourth piezoelectric element 190 connected to the third vibration element 180. In some embodiments, when the fourth piezoelectric element 190 is in the d31 operation mode, a deformation direction of the fourth piezoelectric element 190 may be perpendicular to a vibration direction of the third vibration element 180. In some embodiments, the third vibration element 180 and the vibration element 110 may have the same or different structures, materials, etc. In some embodiments, the fourth piezoelectric element 190 and the piezoelectric element 120 may have the same or different structures, materials, etc. In some embodiments, the beam structure of the third vibration element 180 on both sides of the mass element 130 may be arranged symmetrically, as shown in FIG. 19. In some embodiments, the fourth piezoelectric element 190 may include two piezoelectric sheets located on both sides of the mass element 130. In some embodiments, the fourth piezoelectric element 190 may include one piezoelectric sheet that may completely cover the third vibration element 180 or partially cover the third vibration element 180. More descriptions regarding the third vibration element 180, the fourth piezoelectric element 190 may be respectively found in the related descriptions of the vibration element 110, the piezoelectric element 120, which will not be repeated herein.

It should be noted that the acoustic output device 1900 shown in FIG. 19 is merely provided for the purposes of illustration, and is not intended to limit the scope of the present disclosure. For those skilled in the art, various amendments and variations may be made according to the teachings of the present disclosure. For example, the fourth piezoelectric element 190 may include one piezoelectric sheet that may completely cover the third vibration element 180 or partially cover the third vibration element 180. As another example, the piezoelectric element 120 may include one piezoelectric sheet that may completely cover the vibration element 110.

In some embodiments, the vibration element 110 may have a cantilever beam structure. The cantilever beam has the fixing end 111 and the free end 112. In some embodiments, the third vibration element 180 may have the beam structure. For example, the third vibration element 180 may be a free beam, where at least a portion (e.g., a central area along the length direction) of the free beam is connected to the mass element 130, and both ends of the free beam are free ends. In some embodiments, on a projection plane along the vibration direction of the third vibration element 180 or the vibration direction of vibration element 110, an angle between a length direction (i.e., a direction of a long axis of the free beam) of the third vibration element 180 and the length direction of the vibration element 110 may be 90°. In some embodiments, a connection position of the mass element 130 and the third vibration element 180 may be located at the center of the length direction of the third vibration element 180, i.e., the vibration element 110 and the third vibration element 180 may form a "T" shaped structure (or referred to as a T-beam). In some embodiments, an angle between the length direction of the third vibration element 180 and the length direction of the vibration element 110 may also be less than 90° or greater than 90°. In some embodiments, a connection position of the mass element 130 and the third vibration element 180 may be any position of the length direction of the third vibration element 180.

In some embodiments, the vibration element 110 and the third vibration element 180 may be a "T" shaped structure or any other configuration structures formed integrally. Other configurations include that along the length direction (i.e., an x-direction in the figure) of the vibration element 110, different positions of the vibration elements 110 have different widths (i.e., y-direction in the figure), for example, the larger the width closer to the free end, or the smaller the width closer to the free end.

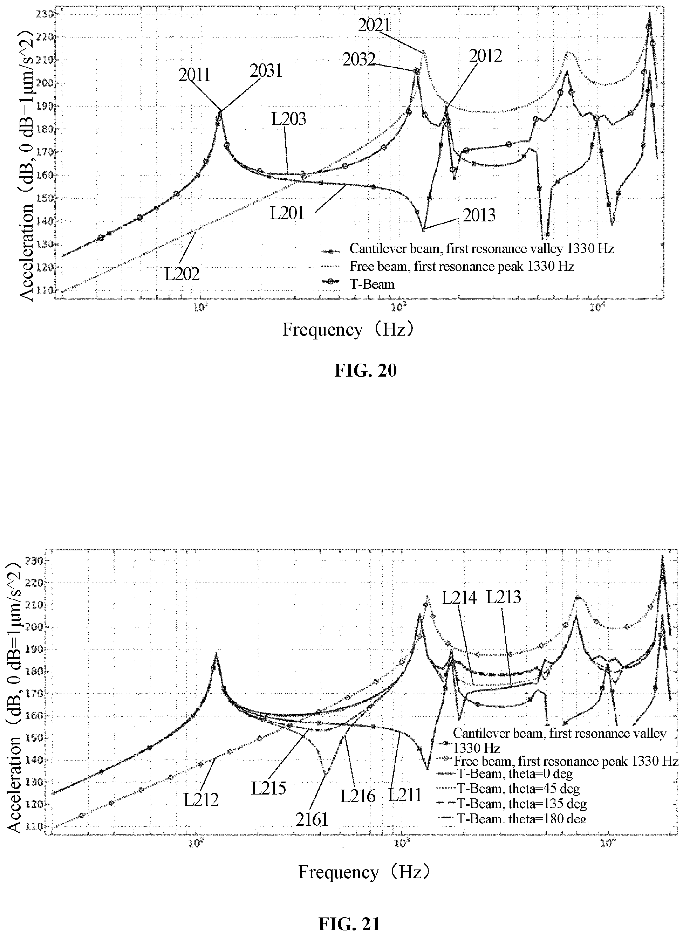

FIG. 20 is a schematic diagram illustrating frequency response curves of acoustic output devices according to some embodiments of the present disclosure.

In FIG. 20, curve L201 is a frequency response curve generated when the piezoelectric element 120 is individually excited (i.e., a frequency response curve generated when the vibration element 110 (or known as the cantilever beam) drives the mass element 130 to vibrate). Curve L202 is a frequency response curve generated when the fourth piezoelectric element 190 is individually excited (i.e., a frequency response curve generated when the third vibration element 180 (or known as the free beam) and the mass element 130 vibrate). Curve L203 is a frequency response curve generated when the piezoelectric element 120 and the fourth piezoelectric element 190 in the acoustic output device 1900 are excited simultaneously (i.e., a frequency response curve generated when the vibration element 110, the third vibration element 180, and the mass element 130 are vibrated simultaneously (or referred to as the T-beam)).

As shown in FIG. 20, curve L201 has at least two resonance peaks (e.g., a first resonance peak 2011 and a second resonance peak 2012) in the audible range (e.g., 20 Hz to 20,000 Hz) of the human ear. There is a resonance valley 2013 between the first resonance 2011 and the second resonance peak 2012. In some embodiments, the first resonance peak 2011 may have a frequency within a range of 50 Hz to 2000 Hz. The frequency of the resonance valley 2013 is about 1330 Hz. Curve L202 has at least one resonance peak (e.g., a resonance peak 2021) in the audible range (e.g., 20 Hz to 20,000 Hz) of the human ear. The frequency of the resonance peak 2021 is about 1330 Hz. Curve L203 has at least two resonance peaks (e.g., a first resonance peak 2031 and a second resonance peak 2032) in the audible range (e.g., 20 Hz to 20,000 Hz) of the human ear. As can be seen from FIG. 20, There is no resonance valley between the first resonance peak 2031 and the second resonance peak 2032 in curve L203. This is because the resonance peak 2021 supplements the resonance valley 2013 with the same frequency, so that there is no resonance valley between the first resonance peak 2031 and the second resonance peak 2032 in curve L203. In addition, in the frequency range greater than 100 Hz, an amplitude of curve L203 is increased relative to curve L201.

Therefore, in some embodiments, the resonance valley between the first resonance peak and the second resonance peak (for ease of description, referred to herein as a resonance valley corresponding to the vibration element 110) that is generated by the vibration of the vibration element 110 and the mass element 130 may be supplemented by the resonance peak (for ease of description, referred to herein as the resonance peak corresponding to the third vibration element 180) that is generated by the vibration of the third vibration element 180 and the mass element 130 within a low frequency range (e.g., 50 Hz to 2000 Hz), so that the frequency response curve of the acoustic output device 1900 does not have the resonance valley between the first and second resonance peaks. Therefore, the curve between the first resonance peak and second resonance peak is smoother, which is beneficial for improving the sound quality of the acoustic output device.

In some embodiments, a ratio of a frequency $f_0$ of the first resonance peak to a frequency $f_1$ of the second resonance peak corresponding to the vibration element 110 may be within a range of 5 to 30. In some embodiments, a ratio of a frequency $f_0$ of the first resonance peak to a frequency $f_1$ of the second resonance peak corresponding to the vibration element 110 may be within a range of 6 to 25. In some embodiments, a ratio of a frequency $f_0$ of the first resonance peak to a frequency $f_1$ of the second resonance peak corresponding to the vibration element 110 may be within a range of 8 to 20. In some embodiments, a ratio of a frequency $f_0$ of the first resonance peak to a frequency $f_1$ of the second resonance peak corresponding to the vibration element 110 may be within a range of 10 to 18.

In some embodiments, the resonance frequency of the beam structure (e.g., the cantilever beam corresponding to the vibration element 110 or the free beam corresponding to the third vibration element 180) may be determined according to equation (2):

$$f_i = \frac{1}{2\pi}(\beta_i l)^2 \sqrt{\frac{EI}{\rho_l l^4}}, (2)$$

where $l$ denotes the length of the beam structure, $EI$ denotes a flexural stiffness of the beam structure, $\rho_l$ denotes a density per unit length of the beam structure, and $\beta_i l$ denotes a coefficient related to an eigenvalue of the $i^{th}$ order resonance frequency. According to equation (2), when the flexural stiffness $EI$ of the beam structure and $\rho_l$ are constant, the resonance frequency of the beam structure varies with the change of $\beta_i l$.

In some embodiments, a frequency equation of the vibration element 110 (the cantilever beam) connected to the mass element 130 may be expressed as:

$$\cos(\beta_i l_1) \cdot \cosh(\beta_i l_1) + 1 = \alpha \cdot \beta_i l_1 \cdot (\sin(\beta_i l_1) \cdot \cosh(\beta_i l_1) - \cos(\beta_i l_1) \cdot \sinh(\beta_i l_1)), (3)$$

where $\alpha$ denotes a ratio of the mass of the mass element 130 to the mass of the vibration element 110, and $\beta_i l_1$ denotes a coefficient related to an eigenvalue of the $i^{th}$ order resonance frequency corresponding to the cantilever beam. By solving the equation (3), the values of $\beta_i l_1$ are shown in Table 1 below:

***Table 1***

| $\alpha$ | $\beta_1 l_1$ | $\beta_2 l_1$ |
|---|---|---|
| 0 | 1.875 | 4.694 |
| 0.1 | 1.723 | 4.4 |
| 0.4 | 1.472 | 4.144 |
| 0.8 | 1.304 | 4.053 |
| 1 | 1.248 | 4.031 |
| 2 | 1.076 | 3.983 |

(continued)

| $\alpha$ | $\beta_1 l_1$ | $\beta_2 l_1$ |
|---|---|---|
| 4 | 0.917 | 3.956 |
| 8 | 0.777 | 3.941 |

In some embodiments, a frequency equation of the third vibration element 180 (the free beam) may be expressed as:

$$cos(\beta_i l_2) \, cosh(\beta_i l_2) - 1 = 0, (4)$$

where $\beta_i l_2$ denotes a coefficient related to an eigenvalue of the $i$th order resonance frequency corresponding the free beam. By solving the equation (4), the value of $\beta_i l_2$ is 4.730, 7.853... (i=1, 2...).

In order to ensure that the resonance peak corresponding to the third vibration element 180 can supplement the resonance valley corresponding to the vibration element 110, in some embodiments, a ratio of a frequency $f_0'$ of the resonance peak corresponding to the third vibration element 180 to a frequency $f_1$ of the second resonance peak corresponding to vibration element 110 may be less than 2. In some embodiments, a ratio of a frequency $f_0'$ of the resonance peak corresponding to the third vibration element 180 to a frequency $f_1$ of the second resonance peak corresponding to vibration element 110 may be less than 1.5. In some embodiments, a ratio of a frequency $f_0'$ of the resonance peak corresponding to the third vibration element 180 to a frequency $f_1$ of the second resonance peak corresponding to vibration element 110 may be less than 1. In some embodiments, a ratio of a frequency $f_0'$ of the resonance peak corresponding to the third vibration element 180 to a frequency $f_1$ of the second resonance peak corresponding to vibration element 110 may be less than 0.5. In some embodiments, in order to ensure that the resonance peak corresponding to the third vibration element 180 can supplement the resonance valley corresponding to the vibration element 110, the frequency $f_0'$ of the resonance peak corresponding to the third vibration element 180 may be close to the frequency of the resonance valley corresponding to the vibration element 110 (e.g., the resonance frequencies of both the resonance valley 2013 and the resonance peak 2021 are around 1330 Hz). Therefore, the frequency $f_0'$ of the resonance peak corresponding to the third vibration element 180 may be smaller than the resonance frequency $f_1$ of the second resonance peak corresponding to the vibration element 110, i.e.,

$$\frac{f_0'}{f_1} = \frac{\frac{1}{2\pi}(\beta_1 l_2)^2 \sqrt{\frac{EI}{\rho_l l_2^4}}}{\frac{1}{2\pi}(\beta_2 l_1)^2 \sqrt{\frac{EI}{\rho_l l_1^4}}} < 1, (5)$$

where a value of $\beta_1 l_2$ is 4.730, and equation (5) may be expressed as

$$\frac{l_2}{l_1} > \frac{4.73}{\beta_2 l_1}. \qquad (6)$$

According to Equation (6) and Table 1, in some embodiments, a ratio of the length of the third vibration element 180 to the length of the vibration element 120 may be greater than 0.7. In some embodiments, a ratio of the length of the third vibration element 180 to the length of the vibration element 120 may be greater than 1. In some embodiments, a ratio of the length of the third vibration element 180 to the length of the vibration element 120 may be greater than 1.2.

Furthermore, according to curve L201 and curve L203, it may be seen that in the mid-to-high frequency band (200 Hz to 20,000 Hz), an amplitude of curve L203 is greater than amplitude of curve L201. Therefore, in some embodiments, in a range greater than 100 Hz, the third vibration element 180 may increase a vibration amplitude of the mass element 130. Therefore, the acoustic output device may have the relatively better sensitivity in the mid-to-high frequency range by using the same or similar structure of the acoustic output device 1900.

FIG. 21 is a schematic diagram illustrating frequency response curves of acoustic output devices according to some embodiments of the present disclosure.

In FIG. 21, curve L211 is a frequency response curve generated when the piezoelectric element 120 is individually excited (i.e., a frequency response curve generated when the vibration element 110 (or known as the cantilever beam) drives the mass element 130 to vibrate). Curve L212 is a frequency response curve generated when the fourth piezoelectric element 190 is individually excited (i.e., a frequency response curve generated when the third vibration element 180 (or known as the free beam) and the mass element 130 vibrate). Curve L213, curve L214, curve L215, and curve L216 are respectively the frequency response curves generated when the piezoelectric element 120 and the fourth piezoelectric element 190 in the acoustic output device 1900 are excited simultaneously and phase differences of excitation signals (denoted by theta in the figure) are 0°, 45°, 135°, and 180°.

According to curve L213, curve L214, curve L215, and curve L216, it may be seen that when a phase difference between an excitation signal of the piezoelectric element 120 and an excitation signal of the fourth piezoelectric element 190 in acoustic output device 1900 exceeds 135°, there may be a resonance valley (e.g., a resonance valley 2161 in curve L216) between the first resonance peak and the second resonance peak in the frequency response curve of the acoustic output device 1900, which is caused by an anti-phase extinction of the vibrations of the vibration element 110 and the third vibration element 180. Therefore, in order to ensure that there is no resonance valley between the first resonance peak and the second resonance peak in the frequency response curve of the acoustic output device 1900, and the acoustic output device 1900 has a large range of flat curves, and thereby having the relatively better sound quality, in some embodiments, a phase difference between an excitation signal of the piezoelectric element 120 and an excitation signal of the fourth piezoelectric element 190 may be less than or equal to 135°. In some embodiments, a phase difference between the excitation signal of the piezoelectric element 120 and the excitation signal of the fourth piezoelectric element 190 may be less than or equal to 90°. In some embodiments, a phase difference between the excitation signal of the piezoelectric element 120 and the excitation signal of the fourth piezoelectric element 190 may be less than or equal to 60°. In some embodiments, a phase difference between the excitation signal of the piezoelectric element 120 and the excitation signal of the fourth piezoelectric element 190 may be less than or equal to 45°. In some embodiments, a phase difference between the excitation signal of the piezoelectric element 120 and the excitation signal of the fourth piezoelectric element 190 may be less than or equal to 30°. In some embodiments, a phase difference between the excitation signal of the piezoelectric element 120 and the excitation signal of the fourth piezoelectric element 190 may be 0°.

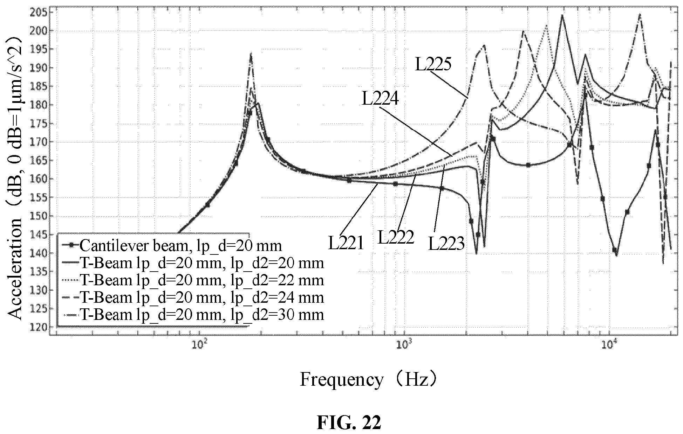

FIG. 22 is a schematic diagram illustrating frequency response curves of acoustic output devices according to some embodiments of the present disclosure.

In FIG. 22, curve L221, curve L222, curve L223, curve L224, and curve L225 are respectively the frequency response curves of the acoustic output device 1900 when the length (denoted by lp_d2 in the figure) of the third vibration element 180 is 0 mm (that is it may be seen that the acoustic output device 1900 does not include the third vibration element 180, which is equivalent to the acoustic output device 200), 20 mm, 22 mm, 24 mm, and 30 mm, wherein the lengths (denoted by lp_d in the figure) of the vibration element 110 are all 20 mm. According to curve L221, curve L222, curve L223, curve L224, and curve L225, it can be seen that when a length of the third vibration element 180 is less than 24 mm, curve L221, curve L222, and curve L223 all have a resonance valley near 2250 Hz. The increases of the length of the third vibration element 180 may only increase the amplitude of the frequency response curve of the acoustic output device 1900 in the mid-to-high frequency range (e.g., 2000 Hz-20000 Hz), which means that the sensitivity of the acoustic output device 1900 in the mid-to-high frequency range may be increased. When a length of the third vibration element 180 exceeds 24 mm, curve L224 and curve L225 do not have a resonance valley between the first resonance peak and the second resonance peak, which makes the frequency response curve of the acoustic output device 1900 relatively flatter, and thereby improving the sound quality. In addition, according to curve L224 and curve L225, as the length of the third vibration element 180 increases, the amplitude of the frequency response curve increases, which is beneficial for improving the sensitivity of the acoustic output device 1900. Furthermore, with the increase of the length of the third vibration element 180, the resonance peak of the frequency response curve of the acoustic output device 1900 in the mid-to-high frequency range (e.g., 2000 Hz-20000 Hz) moves leftwards (i.e., towards the lower frequencies). Therefore, the vibration performance requirements of the acoustic output device 1900 may be met by adjusting the length of the third vibration element 180.

As can be seen from the above, in the acoustic output device 1900, the sensitivity and sound quality of the acoustic output device 1900 may be improved by increasing the length of the third vibration element 180. In some embodiments, the length of the vibration element 110 may be 20 mm, and the length of the third vibration element 180 may be greater than 24 mm. In some embodiments, the length of the third vibration element 180 may be greater than 26 mm. In some embodiments, the length of the third vibration element 180 may be greater than 28 mm. In some embodiments, the length of the third vibration element 180 may be greater than 30 mm.

Having thus described the basic concepts, it may be rather apparent to those skilled in the art after reading this detailed disclosure that the foregoing detailed disclosure is intended to be presented by way of example only and is not limiting. Various alterations, improvements, and modifications may occur and are intended to those skilled in the art, though not expressly stated herein. These alterations, improvements, and modifications are intended to be suggested by this disclosure and are within the spirit and scope of the exemplary embodiments of this disclosure.

Moreover, certain terminology has been used to describe embodiments of the present disclosure. For example, the terms "one embodiment," "an embodiment," and/or "some embodiments" mean that a particular feature, structure, or characteristic described in connection with the embodiment is included in at least one embodiment of the present disclosure. Therefore, it is emphasized and should be appreciated that two or more references to "an embodiment" or "one embodiment" or "an alternative embodiment" in various portions of this specification are not necessarily all referring to the same embodiment. Furthermore, the particular features, structures, or characteristics may be combined as suitable in one or more embodiments of the present disclosure.

Further, it will be appreciated by one skilled in the art, aspects of the present disclosure may be illustrated and described herein in any of a count of patentable classes or context including any new and useful process, machine, manufacture, or collocation of matter, or any new and useful improvement thereof. Accordingly, aspects of the present disclosure may be implemented entirely hardware, entirely software (including firmware, resident software, micro-code, etc.) or combining software and hardware implementation that may all generally be referred to herein as a "unit," "module," or "system." Furthermore, aspects of the present disclosure may take the form of a computer program product embodied in one or more computer readable media having computer-readable program code embodied thereon.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. This method of disclosure, however, is not to be interpreted as reflecting an intention that the claimed subject matter requires more features than are expressly recited in each claim. Rather, claimed subject matter may lie in less than all features of a single foregoing disclosed embodiment.

In some embodiments, the numbers expressing quantities or properties used to describe and claim certain embodiments of the application are to be understood as being modified in some instances by the term "about," "approximate," or "substantially." For example, "about," "approximate," or "substantially" may indicate $\pm20\%$ variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the count of reported significant digits and by applying ordinary rounding techniques. Notwithstanding that the numerical ranges and parameters setting forth the broad scope of some embodiments of the application are approximations, the numerical values set forth in the specific examples are reported as precisely as practicable.

In closing, it is to be understood that the embodiments of the application disclosed herein are illustrative of the principles of the embodiments of the application. Other modifications that may be employed may be within the scope of the application. Therefore, by way of example, but not of limitation, alternative configurations of the embodiments of the application may be utilized in accordance with the teachings herein. Accordingly, embodiments of the present application are not limited to that precisely as shown and described.

## Claims

1. An acoustic output device, comprising:

   a vibration element having a beam structure extending along a length direction of the vibration element;
   a piezoelectric element configured to deform in response to an electrical signal, the deformation of the piezoelectric element driving the vibration element to vibrate, wherein the piezoelectric element is attached to a first position of the beam structure, and a size of an attachment area along the length direction does not exceed 80% of a size of the beam structure along the length direction; and
   a mass element connected to a second position of the beam structure, wherein the first position and the second position are spaced apart along the length direction, and the vibration of the vibration element drives the mass element to vibrate in a direction perpendicular to the length direction.

2. The acoustic output device of claim 1, wherein the vibration element resonates with the mass element to produce a first resonance peak, and a frequency of the first resonance peak is within a range of 50 Hz to 2000 Hz.

3. The acoustic output device of claim 2, wherein the vibration of the vibration element and the mass element has a second resonance peak, and a ratio of a frequency of the second resonance peak to the frequency of the first resonance peak is greater than 5.

4. The acoustic output device of claim 3, wherein between the first resonance peak and the second resonance peak, the vibration of the vibration element and the mass element produces at least one resonance valley, and an amplitude difference between the first resonance peak or the second resonance peak and the at least one resonance valley is less than 80 dB.

5. The acoustic output device of claim 1, wherein a length of the beam structure is less than 50 mm.

6. The acoustic output device of claim 5, wherein a mass of the mass element is less than 10 g.

7. The acoustic output device of claim 1, wherein a deformation direction of the piezoelectric element is perpendicular to a vibration direction of the vibration element.

8. The acoustic output device of claim 7, wherein a length of the piezoelectric element is within a range of 3 mm to 30 mm.

9. The acoustic output device of claim 7, further comprising:
a second piezoelectric element attached to a third position of the beam structure, wherein the piezoelectric element and the second piezoelectric element are spaced apart in the length direction of the vibration element.

10. The acoustic output device of claim 9, wherein a distance between the piezoelectric element and the second piezoelectric element is less than 25 mm.

11. The acoustic output device of claim 9, wherein the beam structure includes a fixing end, and a distance between the piezoelectric element or the second piezoelectric element and the fixing end is greater than 3 mm.

12. The acoustic output device of claim 9, wherein the piezoelectric element and the second piezoelectric element are located on a same side of the beam structure in a vibration direction of the beam structure.

13. The acoustic output device of claim 9, wherein the piezoelectric element and the second piezoelectric element are respectively located at both sides of the beam structure in a vibration direction of the beam structure.

14. The acoustic output device of claim 7, further comprising:
a second mass element, wherein the mass element and the second mass element are respectively located at both sides of the piezoelectric element in the length direction of the vibration element.

15. The acoustic output device of claim 14, wherein a mass of the second mass element is greater than a mass of the mass element.

16. The acoustic output device of claim 15, wherein a ratio of the mass of the second mass element to the mass of the mass element is within a range of 0 to 10.

17. The acoustic output device of claim 1, wherein a deformation direction of the piezoelectric element is parallel to a vibration direction of the vibration element.

18. The acoustic output device of claim 17, wherein the piezoelectric element is fixed at one end along the vibration direction of the vibration element, and another end of the piezoelectric element is connected to the beam structure at the first position.

19. The acoustic output device of claim 18, wherein the beam structure includes a fixing end, and a ratio of a distance between the first position and the fixing end to a length of the beam structure is less than 0.6.

20. The acoustic output device of claim 1, further comprising:
a second vibration element, wherein the vibration element and the second vibration element are arranged symmetrically at both sides of the mass element.

21. The acoustic output device of claim 20, further comprising:
a third piezoelectric element connected to the second vibration element, wherein the third piezoelectric element and the piezoelectric element are arranged symmetrically at the both sides of the mass element.

22. The acoustic output device of claim 20, wherein one end of the vibration element away from the mass element and one end of the second vibration element away from the mass element are fixedly arranged.

23. The acoustic output device of claim 1, further comprising:
a third vibration element connected to the mass element.

24. The acoustic output device of claim 23, wherein in a frequency range greater than 100 Hz, the third vibration element increases a vibration amplitude of the mass element.

25. The acoustic output device of claim 23, wherein a ratio of a length of the third vibration element to a length of the vibration element is greater than 0.7.

26. The acoustic output device of claim 23, wherein a vibration direction of the third vibration element is parallel to a vibration direction of the vibration element.

27. The acoustic output device of claim 26, further comprising:
a fourth piezoelectric element connected to the third vibration element.

28. The acoustic output device of claim 27, wherein a deformation direction of the fourth piezoelectric element is perpendicular to the vibration direction of the third vibration element.

29. The acoustic output device of claim 27, wherein electrical signals received by the piezoelectric element and the fourth piezoelectric element have a phase difference, the phase difference being less than 135°.

<u>100</u>

Housing Structure 210

Vibration
Element 110

Second
Vibration
Element 160

Third
Vibration
Element 180

Piezoelectric
Element
120

Second
Piezoelectric
Element
140

Third
Piezoelectric
Element
170

Fourth
Piezoelectric
Element
190

Mass
Element
130

Second
Mass
Element
150

Fixing Structure
220

**FIG. 1**

<u>200</u>

130

110

120

z

y   x

112

111

**FIG. 2A**

B

A  A'

B'

110

121

122

**FIG. 2B**

FIG. 3A

FIG. 3B

400                                                                                    130

110

111        120

**FIG. 4**

**FIG. 5**

**FIG. 6**

**FIG. 7**

**FIG. 8**

**FIG. 9**

**FIG. 10**

**FIG. 11**

**FIG. 12**

**FIG. 13**

**FIG. 14**

**FIG. 15**

**FIG. 16**

**FIG. 17**

**FIG. 18**

**FIG. 19**

**FIG. 20**

**FIG. 21**

FIG. 22

## INTERNATIONAL SEARCH REPORT

| International application No. |
|---|
| **PCT/CN2022/089572** |

**A. CLASSIFICATION OF SUBJECT MATTER**

H04R 17/02(2006.01)i; H04R 1/10(2006.01)i

According to International Patent Classification (IPC) or to both national classification and IPC

**B. FIELDS SEARCHED**

Minimum documentation searched (classification system followed by classification symbols)

H04R17/-; H04R1/-

Documentation searched other than minimum documentation to the extent that such documents are included in the fields searched

Electronic data base consulted during the international search (name of data base and, where practicable, search terms used)

CNABS, CNTXT, CNKI: 压电, 电, 声, 信号, 转换, 换能, 振动, 质量元件, 质量块, 振动板, 振膜, 梁, 片状, 杆状; WPABS, VEN, USTXT, EPTXT, WOTXT, 百度学术: piezoelectric, acoustic, sound, electrical, signal, transducer, vibration, vibration plate, beam, rod, sheet

**C. DOCUMENTS CONSIDERED TO BE RELEVANT**

| Category* | Citation of document, with indication, where appropriate, of the relevant passages | Relevant to claim No. |
|---|---|---|
| Y | WO 2021196626 A1 (SHENZHEN VOXTECH CO., LTD.) 07 October 2021 (2021-10-07) description, paragraphs [0046]-[0050], and figure 2 | 1-29 |
| Y | CN 104565191 A (SOUTH CHINA UNIVERSITY OF TECHNOLOGY) 29 April 2015 (2015-04-29) description, paragraphs [0037]-[0040], and figure 1 | 1-29 |
| A | CN 110611865 A (SHENZHEN VOXTECH CO., LTD.) 24 December 2019 (2019-12-24) entire document | 1-29 |
| A | CN 105934835 A (MICROFINE MATERIALS TECHNOLOGIES PTE LTD.) 07 September 2016 (2016-09-07) entire document | 1-29 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 January 2023** | **28 January 2023** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

International application No.

**PCT/CN2022/089572**

| Patent document cited in search report | | | Publication date (day/month/year) | Patent family member(s) | | | Publication date (day/month/year) |
|---|---|---|---|---|---|---|---|
| WO | 2021196626 | A1 | 07 October 2021 | KR | 20220146570 | A | 01 November 2022 |
| | | | | US | 2022312108 | A1 | 29 September 2022 |
| | | | | CN | 115152246 | A | 04 October 2022 |
| | | | | CA | 3176100 | A1 | 07 October 2021 |
| | | | | CN | 115280793 | A | 01 November 2022 |
| | | | | KR | 20220133268 | A | 04 October 2022 |
| | | | | PE | 20221843 | A1 | 30 November 2022 |
| | | | | BR | 112022017897 | A2 | 01 November 2022 |
| | | | | WO | 2021196624 | A1 | 07 October 2021 |
| | | | | CO | 2022013931 | A2 | 21 October 2022 |
| | | | | US | 2022386021 | A1 | 01 December 2022 |
| | | | | CA | 3171893 | A1 | 07 October 2021 |
| | | | | WO | 2021196795 | A1 | 07 October 2021 |
| | | | | US | 2022386011 | A1 | 01 December 2022 |
| | | | | BR | 112022012429 | A2 | 11 October 2022 |
| | | | | EP | 4059228 | A1 | 21 September 2022 |
| | | | | KR | 20220133970 | A | 05 October 2022 |
| | | | | EP | 4062655 | A1 | 28 September 2022 |
| | | | | CN | 115066911 | A | 16 September 2022 |
| | | | | CO | 2022013075 | A2 | 09 December 2022 |
| | | | | BR | 112022013213 | A2 | 18 October 2022 |
| | | | | EP | 4091336 | A1 | 23 November 2022 |
| | | | | AU | 2020440893 | A1 | 27 October 2022 |
| | | | | AU | 2020439803 | A1 | 08 September 2022 |
| CN | 104565191 | A | 29 April 2015 | CN | 104565191 | B | 22 February 2017 |
| CN | 110611865 | A | 24 December 2019 | CN | 210868093 | U | 26 June 2020 |
| | | | | CN | 112438054 | A | 02 March 2021 |
| | | | | CN | 210868153 | U | 26 June 2020 |
| | | | | US | 2022150637 | A1 | 12 May 2022 |
| | | | | CN | 210868150 | U | 26 June 2020 |
| | | | | CN | 210868152 | U | 26 June 2020 |
| | | | | AU | 2019285891 | A1 | 28 January 2021 |
| | | | | CN | 210868155 | U | 26 June 2020 |
| | | | | CL | 2020003229 | A1 | 09 April 2021 |
| | | | | CN | 115297418 | A | 04 November 2022 |
| | | | | CN | 115334421 | A | 11 November 2022 |
| | | | | WO | 2019237727 | A1 | 19 December 2019 |
| | | | | US | 2021168509 | A1 | 03 June 2021 |
| | | | | NZ | 771862 | A | 01 July 2022 |
| | | | | CO | 2021000024 | A2 | 08 March 2021 |
| | | | | IL | 279394 | A | 31 January 2021 |
| | | | | CN | 209627681 | U | 12 November 2019 |
| | | | | CN | 210868156 | U | 26 June 2020 |
| | | | | EP | 3796670 | A1 | 24 March 2021 |
| | | | | CN | 110611866 | A | 24 December 2019 |
| | | | | PE | 20210542 | A1 | 17 March 2021 |
| | | | | US | 2021092525 | A1 | 25 March 2021 |
| | | | | KR | 20210020102 | A | 23 February 2021 |
| | | | | CN | 210868147 | U | 26 June 2020 |
| | | | | CN | 115297417 | A | 04 November 2022 |

**INTERNATIONAL SEARCH REPORT**
Information on patent family members

International application No.

**PCT/CN2022/089572**

| Patent document cited in search report | | | Publication date (day/month/year) | Patent family member(s) | | | Publication date (day/month/year) |
|---|---|---|---|---|---|---|---|
| | | | | BR | 112020025564 | A2 | 16 March 2021 |
| | | | | RU | 2022100074 | A | 01 February 2022 |
| | | | | CN | 209358770 | U | 06 September 2019 |
| | | | | RU | 2764239 | C1 | 14 January 2022 |
| | | | | KR | 20220043249 | A | 05 April 2022 |
| | | | | CN | 115334420 | A | 11 November 2022 |
| | | | | JP | 2022119789 | A | 17 August 2022 |
| | | | | CN | 210868149 | U | 26 June 2020 |
| | | | | CN | 115297416 | A | 04 November 2022 |
| | | | | CA | 3103583 | A1 | 19 December 2019 |
| | | | | JP | 2021527364 | A | 11 October 2021 |
| | | | | CN | 210868151 | U | 26 June 2020 |
| | | | | CN | 210868148 | U | 26 June 2020 |
| | | | | US | 11310601 | B2 | 19 April 2022 |
| | | | | AU | 2019285891 | B2 | 23 June 2022 |
| | | | | CN | 112438054 | B | 12 August 2022 |
| | | | | KR | 102446016 | B1 | 22 September 2022 |
| CN | 105934835 | A | 07 September 2016 | TW | 201547288 | A | 16 December 2015 |
| | | | | JP | 2017512391 | A | 18 May 2017 |
| | | | | WO | 2015126321 | A1 | 27 August 2015 |
| | | | | CA | 2929137 | A1 | 27 August 2015 |
| | | | | KR | 20160120286 | A | 17 October 2016 |
| | | | | US | 2016346809 | A1 | 01 December 2016 |
| | | | | AU | 2014383192 | A1 | 05 May 2016 |
| | | | | SG | 11201602832 P | A | 30 May 2016 |
| | | | | EP | 3108511 | A1 | 28 December 2016 |
| | | | | SG | 11201602832 | B | 17 May 2017 |
| | | | | TW | 592029 | B1 | 11 July 2017 |
| | | | | EP | 3108511 | A4 | 06 September 2017 |
| | | | | JP | 6265573 | B2 | 24 January 2018 |
| | | | | EP | 3108511 | B1 | 10 October 2018 |
| | | | | CN | 105934835 | B | 19 March 2019 |
| | | | | US | 10315223 | B2 | 11 June 2019 |
| | | | | CA | 2929137 | C | 16 February 2021 |
| | | | | KR | 102236545 | B1 | 07 April 2021 |

Form PCT/ISA/210 (patent family annex) (January 2015)